# EUROPÄISCHE PATENTSCHRIFT

(11) **EP 2 671 029 B1**
(45) Veröffentlichungstag und Bekanntmachung des Hinweises auf die Patenterteilung: **10.04.2019**
(21) Anmeldenummer: 12706210.7
(22) Anmeldetag: 01.02.2012
(51) Int. Cl.: F24D 3/08, G05D 23/19, G06Q 50/06

(54) **HEIZSYSTEM UND VERFAHREN ZUM HEIZEN EINES GEBÄUDES UND/ODER ZUR WARMWASSERBEREITUNG**
HEATING SYSTEM AND METHOD FOR HEATING A BUILDING AND/OR FOR PREPARING HOT WATER
SYSTÈME DE CHAUFFAGE ET PROCÉDÉ DE CHAUFFAGE D'UN IMMEUBLE ET/OU DE PRODUCTION D'EAU CHAUDE

(30) Priorität: 01.02.2011 DE 102011000444
(43) Veröffentlichungstag der Anmeldung: 11.12.2013
(73) Patentinhaber: AoTerra GmbH, 01187 Dresden (DE)
(72) Erfinder: STRUCKMEIER, Jens, 01277 Dresden (DE); FETZER, Christof, 01277 Dresden (DE)
(74) Vertreter: Viering, Jentschura & Partner mbB Patent- und Rechtsanwälte
(86) Internationale Anmeldenummer: PCT/EP2012/051707
(87) Internationale Veröffentlichungsnummer: WO 2012/104354

(56) Entgegenhaltungen:
- EP-B1- 1 319 155
- WO-A1-2010/019517
- DE-B3-102005 021 473
- JP-A- 11 023 016
- US-A1- 2009 218 078
- US-A1- 2009 265 568
- US-A1- 2010 217 454
- US-A1- 2011 042 059
- US-A1- 2012 158 190

## Beschreibung

Die Erfindung betrifft ein Heizsystem zum Heizen eines Gebäudes, einen Rechner eines Heizsystems zum Heizen eines Gebäudes und einen Rechenlastverteilungs-Rechner zum Verteilen und Koordinieren von Rechenaufgaben. Ferner betrifft die Erfindung ein Verfahren zum Betreiben eines Heizsystems zum Heizen eines Gebäudes sowie ein Verfahren zum Betreiben eines Rechenlastverteilungs-Rechners.

Heutzutage gewinnt der Umweltschutz und insbesondere der Gedanke der Nachhaltigkeit immer mehr an Bedeutung. Einen Aspekt stellt dabei das sogenannte "Green computing" (grünes Rechnen) dar - das umweltfreundliche und effiziente Verwenden von Informationstechnologien, die in unserer heutigen Welt kaum mehr wegzudenken sind. Dieser Ansatz gewinnt zunehmend an Bedeutung, nicht zuletzt wegen dem steigenden Einsatz großer Rechenzentren in Industrie und Forschung. Trotz der Verwendung moderner und effizienter Komponenten wird von der Rechenarchitektur in Rechenzentren sehr viel Abwärme produziert, die prinzipiell eine Verlustleitung darstellt. Bedenkt man ferner, dass bis zu 50 Prozent der Energie nicht für die Rechenleistung selbst, sondern für die notwendige Kühlung aufgewendet wird, so wird das immense Potential des "Green computing" für die Umwelt deutlich.

Eine Möglichkeit besteht darin, die von einem Großrechner erzeugte Abwärme als Nutzwärme im Rechenzentrumsgebäude bereitzustellen. Als ein Beispiel dafür sei der Supercomputer Aquasar von IBM an der ETH Zürich genannt, welcher einen wasserbasierten Kühlkreislauf aufweist, der den aufgenommenen Teil der Abwärme durch einen Wärmetauscher an eine konventionelle Gebäudeheizung der ETH Zürich abgibt und so die anderen Energiequellen bei der Bereitstellung der Wärme unterstützt.

Eine weitaus größere Umweltbelastung als Rechenzentren stellt jedoch der Energieverbrauch von Gebäuden dar, welcher beispielsweise in der EU für circa. 40% der konsumierten Energie verantwortlich ist, wobei bei Privathaushalten der Großteil der Energie zur Wärmeerzeugung verwendet wird. Heizsysteme in Gebäuden basieren größtenteils weiterhin auf primären (meist fossile Brennstoffe) und sekundären (Strom) Energieträgern, unterstützt von regenerativen Energieträgern, beispielsweise Sonnen- und Windkraft.

Die Druckschrift US 2009/0265568 A1 beschreibt ein Verfahren zu dem Verwalten des Energieverbrauchs in einer Umgebung mit Computern. Anhand der Rechenlast des Computers kann der Energieverbrauch modifiziert werden.

Die Druckschrift WO 02/25176 A1 beschreibt ein Heizsystem mit einer zentralen Heizeinheit, welche lokale Einheiten mit einer geheizten Flüssigkeit versorgt, wobei die lokalen Einheiten eine Kontrollinstanz aufweisen, welche der zentralen Einheit einen Wärmebedarf mitteilen.

Im Hinblick auf die eben angeführten Umstände besteht die Aufgabe der Erfindung in der Schaffung von Vorrichtungen und Verfahren, die ein neuartiges, effizientes und umweltfreundlicheres Heizen eines Gebäudes ermöglichen.

Diese Aufgabe wird mit den Merkmalen gemäß den unabhängigen Patentansprüchen gelöst. Ausgestaltungen finden sich in den abhängigen Patentansprüchen.

Den verschiedenen Ausführungsbeispielen ist anschaulich gemeinsam, dass der Ansatz des "Green computing" auf neuartige Art und Weise in Verbindung mit dem Vorhaben gebracht wird, Gebäude effizient zu heizen. Anstatt den bisher üblichen Weg zu gehen, die Abwärme eines Rechenzentrums über ein Fernwärmenetz auf technisch aufwendige und kostspielige Art und Weise abzuführen, wird der Ansatz verfolgt, Heizsysteme auf Basis von Rechnern auf Gebäude zu verteilen und so die Wärme - in Form von Abwärme der Rechner - direkt in den Gebäuden entstehen zu lassen und sie auch dort zu verwerten. Dadurch kann auf ein kostspieliges und aufwendiges Fernwärmenetz verzichtet werden und es kann eine flächendeckende Bereitstellung von Nutzwärme an Gebäude erfolgen. Die Rechner sind in der Lage bzw. so eingerichtet oder dimensioniert, den Wärmebedarf des jeweiligen Gebäudes und/oder des Heizsystems, in das sie eingebunden sind, zu ermitteln und diesen an den Rechenlastverteilungs-Rechner zu übermitteln. Der Rechenlastverteilungs-Rechner überwacht und steuert die Rechenlast jedes Rechners, mitunter in Abhängigkeit von dem Wärmebedarf des Heizsystems und/oder des Gebäudes, wobei die Rechenlast des Rechners für die Menge der erzeugten Abwärme ausschlaggebend ist. Die Kommunikation zwischen dem Rechenlastverteilungs-Rechner und einem jeweiligen Rechnern erfolgt dabei über ein Netzwerk, beispielsweise das Internet.

Ein Heizsystem basierend auf dem eben umrissenen Leitgedanken bringt viele Vorteile mit sich. Wie eingangs erwähnt, wird dadurch zum einen dem "Green computing" Rechnung getragen, da die Abwärme eines Rechenzentrums so besonders effektiv zum Heizen von Gebäuden verwendet werden kann. Ferner werden Umweltressourcen geschont, da sowohl der aufwendige Bau eines Fernwärmenetzes wie auch die Errichtung der baulichen Infrastruktur für ein Rechenzentrum entfallen. Beide Aspekte spielen bei der Vermeidung von CO₂-Emissionen eine große Rolle. Die Erzeugung von Abwärme durch Rechner eines verteilten Rechenzentrums in einem Gebäude und/oder Wohnhaus - also direkt beim Abnehmer - ist insbesondere im Hinblick auf energiesanierte Häuser sowie Neubauten attraktiv, deren Heizenergieverbrauch stark reduziert ist. Ihr Energiebedarf könnte durch das hier vorgestellte Heizsystem vollständig gedeckt werden. Nicht zuletzt ermöglicht das nachfolgend detaillierter erläuterte Heizsystem eine vereinfachte Migration in bestehende Gebäudearchitekturen, da es für seinen Betrieb sowohl von einem verfügbaren InternetAnschluss wie auch von Teilen eines bereits im Gebäude bestehenden Heizungssystems Gebrauch macht.

So ist beispielsweise in modernen Niedrigenergie- und Passivhäusern in der Regel eine zentrale Anlage zur kontrollierten Wohnungslüftungsfunktionalität und integriertem Gegen- oder Kreuzstromwärmetauscher installiert. Im Falle eines Passivhauses wird für gewöhnlich die Vorerwärmung der von der Außenumgebung des Hauses in sein Inneres angesaugten Frischluft über einen entsprechend dimensionierten Erdreichwärmetauscher realisiert. Die mittlere Luftwechselrate beträgt typischerweise 0,5 pro Stunde, bezogen auf das Gebäudevolumen. Ein typischer Wert für ein Einfamilienhaus beträgt 160 m³ pro Stunde

Im Einzelnen wird also in verschiedenen Ausführungsbeispielen ein Heizsystem zum Heizen eines Gebäudes und/oder zur Warmwasserbereitung und zur Integration in ein Heizsystem-Netzwerk mit einer Vielzahl von Heizsystemen bereitgestellt, wobei das Heizsystem eine Wärmeverteilungseinrichtung und mindestens einen Rechner aufweist, wobei der Rechner mit der Wärmeverteilungseinrichtung derart gekoppelt ist, dass die von ihm erzeugte Wärme mittels der Wärmeverteilungseinrichtung im Gebäude verteilt werden kann. Der Rechner ist so eingerichtet, dass er eine Nachricht für einen Rechenlastverteilungs-Rechner, der Rechenaufgaben an die Rechner der Heizsysteme des Heizsystem-Netzwerks verteilt und koordiniert, erzeugt, wobei die Nachricht eine Information über einen Wärmebedarf des Heizsystems und/oder des Gebäudes enthält. Der Rechner weist außerdem einen Empfänger auf, der eingerichtet ist zum Empfangen einer oder mehrerer Nachrichten von dem Rechenlastverteilungs-Rechner, wobei in der einen oder den mehreren Nachrichten die Durchführung von Berechnungen angefordert wird, und wobei der Rechner derart eingerichtet ist, dass er die mittels der einen oder mehreren empfangenen Nachrichten angeforderten Berechnungen durchführt.

Bei der Wärmeverteilungseinrichtung kann es sich gemäß verschiedenen Ausführungsbeispielen um eine Vorrichtung handeln, welche eingerichtet ist die im Heizsystem bereitstehende Wärme im Gebäude zu verteilen, beispielsweise die vom Rechner erzeugte Abwärme. Dazu kann die Wärmeverteilungseinrichtung ein oder mehrere Rohre, und/oder eine oder mehrere Leitungen, und/oder einen oder mehrere Durchflussregler sowie optional eine oder mehrere weitere strömungstechnische Einrichtungen aufweisen, das oder die mit einem Fluid gefüllt ist oder sind, mittels dessen oder derer von dem Rechner erzeugte Wärme im Gebäude verteilt wird. Die Wärmebereitstellung durch die Wärmeverteilungseinrichtung kann auch die Bereitstellung von Warmwasser vorsehen. Es können ferner weitere zweckdienliche Elemente an die Wärmeverteilungseinrichtung angeschlossen sein bzw. die Wärmeverteilungseinrichtung kann diese aufweisen, beispielsweise mindestens eine weitere Energiezufuhr (z.B. auf Basis von Kohle, Heizöl, Strom, Sonnenlicht usw.), mindestens eine Vorrichtung zum Umwandeln der Energiezufuhr in Wärme (z.B. einen Heizkessel), mindestens eine Vorrichtung zur Speicherung der Wärme (z.B. einen Wärmespeicher) und mindestens eine Vorrichtung zur Übertragung der Wärme an Räume (z.B. Heizkörper). Das den Rechner kühlende Fluid, beispielsweise Luft, kann als solche von der Wärmeverteilungseinrichtung direkt verwendet werden, beispielsweise um Räume zu temperieren, oder aber auch mittels einer Kopplung über beispielsweise einen Wärmetauscher seine Wärme auf ein anderes Fluid, beispielsweise Wasser, übertragen und dann mittels der Wärmeverteilungseinrichtung im Gebäude verteilt werden. Weiterhin kann die Wärmeenergie, die in dem Fluid enthalten ist, welches den Rechner kühlt, in eine andere Energieform, beispielsweise mittels einer Turbine in Strom, umgewandelt werden und so der Wärmeverteilungseinrichtung zugeführt werden. Anders ausgedrückt kann der Rechner direkt an die Wärmeverteilungseinrichtung gekoppelt sein oder mittels eines Wärmetauschers an die Wärmeverteilungseinrichtung gekoppelt sein. Der Wärmebedarf des Heizsystems und/oder des Gebäudes kann hierbei beispielsweise die Wärme berücksichtigen, welche sowohl momentan erforderlich ist, um das Gebäude mit Wärme mittels der Wärmeverteilungseinrichtung zu versorgen (beispielsweise Warmwasser oder Klimatisierung der Raumluft) wie auch die Wärme, die nicht unmittelbar an das Gebäude abgegeben wird, sondern beispielsweise im Wärmespeicher zwischengespeichert wird. In diesem Zusammenhang kann die von dem Rechner erzeugte Nachricht sowohl auf den momentanen Wärmebedarf und/oder auf Grundlage von Prognosen bzw. einer Historie der Wärmebereitstellung in der Vergangenheit vorhergesagten Wärmebedarf abstellen. Das Gebäude, in dem das Heizsystem installiert ist, kann ein beliebiges Gebäude sein, beispielsweise ein Einfamilienhaus, ein Mehrfamilienhaus, ein Wohnhaus, ein Bürogebäude, ein kommerziell genutztes Gebäude wie beispielsweise ein Supermarkt, oder eine öffentliche Einrichtung, wie zum Beispiel eine Sportstätte.

Gemäß einem Ausführungsbeispiel des Heizsystems kann der Rechner einen Sender aufweisen, der eingerichtet ist derart, dass die erzeugte Nachricht an den Rechenlastverteilungs-Rechner gesendet wird. Der Sender kann ein separates Modul sein oder mittels des Rechners implementiert sein. Zum Versenden der Nachricht kann eine Verbindung des Rechners mit der Außenwelt, beispielsweise ein Internetanschluss und/oder eine Mobilfunkverbindung, verwendet werden oder es kann eine separate Verbindung verwendet werden.

In verschiedenen Ausführungsbeispielen kann das Heizsystem eine Steuereinrichtung aufweisen, die mit dem Rechner gekoppelt ist oder mittels des Rechners implementiert ist, wobei die Steuereinrichtung eingerichtet ist zum Steuern des Heizsystems. Die Steuereinrichtung kann auch optional eingerichtet sein zum Ausführen steuertechnischer Aufgaben im Strom- und Datennetz des Gebäudes.

Gemäß verschiedenen Ausführungsformen des Heizsystems kann die Steuervorrichtung zum Ausführen von Steuerprozessen zum Erfassen von mindestens einem für den Betrieb des Heizsystems erforderlichen Parameters eingerichtet sein. Bei dem Parameter kann es sich beispielsweise um eine Wärmemenge, welche von dem Rechner geliefert wird oder welche zum Heizen des Gebäudes erforderlich ist, eine Temperatur, beispielsweise von Räumen oder dem Rechner, eine Luftfeuchte, beispielsweise von Räumen im Gebäude oder von der Außenumgebung und eine Tageszeit handeln. Zum Erfassen der Parameter können entsprechende Sensoren, wie beispielsweise ein Wärmemengensensor, ein Temperatursensor, ein Luftfeuchtesensor, ein Stromverbrauchssensor, ein Lichtsensor, ein Windsensor, ein Kohlendioxidsensor ein Feuermeldesensor, ein Wasserverbrauchssensor und/oder eine Uhr vorgesehen sein, die an entsprechenden Stellen innerhalb und/oder außerhalb des Gebäudes angebracht sein können. Die Sensoren können von der Steuereinrichtung gesteuert werden oder selbstständig arbeiten. Die Kommunikation zwischen den Sensoren und der Steuereinheit kann drahtlos oder drahtgebunden erfolgen. Ferner können die oben genannten Sensoren zur Erzeugung von Schätzwerten für die von ihnen zu bestimmenden Parameter eingerichtet sein, indem sie beispielsweise aufgezeichnete Werte aus der Vergangenheit speichern und auf Grundlage dieser Werte mittels eines Schätz- bzw. Prognose- bzw. Interpolationsalgorithmus Schätz- bzw. Prognose- bzw. Interpolationswerte erzeugen. Diese Funktionalität kann aber auch mittels der Steuereinrichtung implementiert werden, indem diese die Speicherung und entsprechende Auswertung von Messwerten der jeweiligen Sensoren übernimmt. Die Steuereinrichtung kann auch zur Einholung von Messdaten, beispielsweise über das Internet, eingerichtet sein, so dass beispielsweise bei Ausfall eines Sensors entsprechende Ersatzmesswerte abgefragt werden können, beispielsweise von Wettermessstationen in der Umgebung des Gebäudes.

Gemäß verschiedenen Ausführungsformen des Heizsystems kann dieses ferner einen Empfänger aufweisen, der eingerichtet ist zum Empfangen einer oder mehrerer Nachrichten von dem Rechenlastverteilungs-Rechner, wobei in der einen oder den mehreren Nachrichten die Durchführung von Berechnungen angefordert wird. Der Empfänger kann ein separates Modul sein oder mittels des Rechners implementiert sein. Zum Empfangen der Nachricht kann eine Verbindung des Rechners mit der Außenwelt, beispielsweise ein Internetanschluss und/oder eine Mobilfunkverbindung, verwendet werden. Der Rechner kann ferner derart eingerichtet sein, dass er die mittels der einen oder mehreren empfangenen Nachrichten angeforderten Berechnungen durchführt. Die angeforderten Berechnungen oder auch Teile davon können sofort oder zu einem späteren Zeitpunkt durchgeführt werden. Eine Ausführung zu einem späteren Zeitpunkt kann beispielsweise an bestimmte Bedingungen geknüpft sein, wie Fallen des Strompreises unter eine vorbestimmte Preisschwelle. Weitere Bedingungen können beispielsweise an bestimmte Parameterwerte geknüpft sein, die von den Sensoren bereitgestellt werden, beispielsweise Erreichen einer bestimmten Außentemperatur oder Unterschreiten einer bestimmten Sonnenscheindauer. Die empfangenen Nachrichten können beliebige Parameter und/oder Daten enthalten, die zur Durchführung der Berechnungen vorgesehen oder gewünscht sind, beispielsweise Programmanweisungen, Datensätze, Skripte. Unter Berechnungen, die ein Rechner durchführt, sind hierbei sämtliche Prozesse zu verstehen, die ein Rechner ausführen muss, um Daten zu Berechnen und/oder zu Speichern und/oder zu Prozessieren und/oder in beliebiger Weise anderweitig zu verarbeiten, beispielsweise Ausführen von Skripten und/oder Programmen wie Verschlüsselungs-, Komprimierungs-, Kompilierungsaufgaben und/oder Bereitstellen kompletter virtueller Maschinen und/oder Bereitstellen von Speicher- und/oder Archivierungsdiensten auf Speichermedien.

In verschiedenen Ausführungsbeispielen kann das Heizsystem einen Wärmetauscher aufweisen, der mittels des Rechners mit der Wärmeverteilungseinrichtung gekoppelt ist. Zusätzlich kann das Heizsystem eine Luftzuführeinrichtung aufweisen, die mittels des Wärmetauschers mit dem Rechner gekoppelt ist derart, dass zugeführte Luft zur Kühlung des Rechners dient. Durch die Anordnung eines Wärmetauschers zwischen der Luftzufuhreinrichtung und dem Rechner kann die zugeführte Luft bei Bedarf, beispielsweise bei einer kühlen Außentemperatur, von der Luft, die aus dem Gebäude abgeführt werden soll, vorgewärmt werden.

Gemäß einer weiteren Ausführungsform des Heizsystems kann die Luftzuführeinrichtung ferner einen Bypass aufweisen, der unter Umgehung des Wärmetauschers eine Kopplung mit dem Rechner bereitstellt. Dadurch ist es möglich, durch die Luftzuführeinrichtung zur Kühlung des Rechners bereitgestellte Luft ohne Umwege zum Rechner zu leiten und so eine möglichst geringe Vorerwärmung sicher zu stellen, was besonders zur warmen Jahreszeit vorteilhaft ist.

Gemäß einer weiteren Ausführungsform des Heizsystems kann der Rechner einen Bypass aufweisen, der eine Kopplung der Wärmeverteilungseinrichtung mit dem Wärmetauscher unter Umgehung des Rechners bereitstellt. Dadurch ist es möglich, aus dem Gebäude abzuführende Luft, die ihre Wärme als Heizleistung an Räume abgegeben hat, unter Umgehung des Rechners in den Wärmetauscher zu führen und anschließend aus dem Gebäude abzuführen.

In verschiedenen Ausführungsbeispielen des Heizsystems kann eine mit dem Rechner gekoppelte Struktur vorliegen, die eine direkte Kopplung des Rechners mit der Außenwelt zur Kühlung des Rechners bereitstellt. Durch eine solche Struktur ist es möglich, Abwärme des Rechners mittels der zur Kühlung bereitgestellten Luft abzuführen und diese unmittelbar an die Außenwelt zu leiten. Die Struktur ist somit vorteilhaft für Fälle, in denen beispielsweise der Rechner zu viel Abwärme erzeugt und/oder der Wärmebedarf des Heizsystems und/oder des Gebäudes gedeckt ist.

Gemäß einer weiteren Ausführungsform weist das Heizsystem einen Wärmespeicher auf, z.B. einen Pufferspeicher, einen Schichtenspeicher, und/oder ein Schwimmbad. Der Wärmespeicher kann auch mittels einer Betonkerntemperierung bereitgestellt werden. Durch das Vorsehen eines Wärmespeichers ist es möglich, die von dem Rechner erzeugte Abwärme über ein Fluid in dem Wärmespeicher zu speichern und die Wärme dann beispielsweise zeitersetzt an das Gebäude oder an eine Warmwasserversorgung des Gebäudes abzugeben.

Ferner wird in verschiedenen Ausführungsbeispielen ein Rechner eines Heizsystems in ein Heizsystem-Netzwerk mit einer Vielzahl von Heizsystemen zum Heizen eines Gebäudes und/oder zur Warmwasserbereitung bereitgestellt, wobei der Rechner mit einer Wärmeverteilungseinrichtung derart gekoppelt ist, dass die von ihm erzeugte Wärme mittels der Wärmeverteilungseinrichtung im Gebäude verteilt werden kann. Ferner ist der Rechner so eingerichtet ist, dass er eine Nachricht für einen Rechenlastverteilungs-Rechner, der Rechenaufgaben an Rechner einer Vielzahl von Heizsystemen verteilt und koordiniert, erzeugt, wobei die Nachricht eine Information über einen Wärmebedarf des Heizsystems und/oder des Gebäudes enthält, und wobei der Rechner einen Empfänger aufweist, der eingerichtet ist zum Empfangen einer oder mehrerer Nachrichten von dem Rechenlastverteilungs-Rechner, wobei in der einen oder den mehreren Nachrichten die Durchführung von Berechnungen angefordert wird, und wobei der Rechner derart eingerichtet ist, dass er die mittels der einen oder mehreren empfangenen Nachrichten angeforderten Berechnungen durchführt.

Gemäß einem weiteren vorteilhaften Ausführungsbeispiel des Rechners weist dieser mindestens einen Anschluss zum Bereitstellen von Kühlluft und mindestens einen weiteren Anschluss zum Abführen von Kühlluft auf. Der eine Anschluss kann vorgesehen sein, um den Rechner beispielsweise mit dem Wärmetauscher zu verbinden, so dass die Möglichkeit gegeben ist beispielsweise Kühlluft vor Eintritt in den Rechner vorzuwärmen. Der weitere Anschluss kann vorgesehen sein, um den Rechner beispielsweise an eine Wärmeverteilungseinrichtung des Gebäudes anzuschließen, so dass die erwärmte den Rechner verlassende Kühlluft ihre Wärme an die Wärmeverteilungseinrichtung abgeben kann.

In verschiedenen Ausführungsbeispielen kann der Rechner derart eingerichtet sein, dass er die mittels der einen oder mehreren empfangenen Nachrichten angeforderten Berechnungen durchführt. Das Aufgabenfeld des Rechners ist jedoch darauf nicht beschränkt. So können auf dem Rechner beispielsweise andere als die angeforderten Berechnungen durchgeführt werden, beispielsweise Berechnungen, die für den Betrieb des Heizsystems erforderlich sind oder die über Terminals, die mit dem Rechner verbunden sind, von den sich im Gebäude aufhaltenden Personen angefordert werden.

In verschiedenen Ausführungsbeispielen kann der Rechner einen oder mehrere Rechenknoten aufweisen, vorzugsweise maximal 30 Rechenknoten, weiter vorzugsweise maximal 10 Rechenknoten. Jeder der Rechenknoten kann dabei ein Mainboard mit mindestens einem Prozessor mit jeweils mindestens einem Kern. An das Mainboard kann mindestens ein Speichermedium, beispielsweise in Form einer Festplatte oder eines SSD (solid state drive - Festkörperlaufwerk), und mindestens eine Netzwerkkarte bzw. ein Netzwerkadapter angeschlossen sein. Typischerweise basiert der Aufbau des Rechners auf einem Server-Rack (Server-Baugruppenträger), in den die Rechenknoten in Form von Einsteckplatinen eingesteckt werden, wobei er entsprechend zur Aufnahme und Abgabe von Kühlluft angepasst ist. Die Rechenknoten könnten miteinander mittels einer Weiche, beispielsweise einem Switch oder Router, gekoppelt sein.

Gemäß einem weiteren Ausführungsbeispiel ist der Rechner das einzige an die Wärmeverteilungseinrichtung des Gebäudes gekoppelte Heizelement. In einem solchen Fall kann der Wärmebedarf vollständig durch die Abwärme des Rechners gedeckt werden, was einen besonders umweltfreundlichen und nachhaltigen Weg zum Heizen eines Gebäudes darstellt.

Im Zusammenhang mit dem Heizsystem wird gemäß verschiedenen Ausführungsbeispielen ein Verfahren zum Betreiben eines Heizsystems bereitgestellt, welches mindestens einen Rechner aufweist und in ein Heizsystem-Netzwerk mit einer Vielzahl von Heizsystemen integriert ist, zum Heizen eines Gebäudes und/oder zur Warmwasserbereitung. Das Verfahren weist das Ermitteln eines Wärmebedarfs des Heizsystems (106) und/oder des Gebäudes (104) und/oder des Wassers und das Erzeugen einer Nachricht für einen Rechenlastverteilungs-Rechner auf, der Rechenaufgaben an den mindestens einen Rechner (102) des Heizsystems (106) verteilt und koordiniert, mit einer Information über den Wärmebedarf des Heizsystems (106) und/oder des Gebäudes (104) mittels des Rechners (102). Ferner weist das Verfahren das Empfangen mittels eines Empfängers des Rechners einer oder mehrerer Nachrichten von dem Rechenlastverteilungs-Rechner auf, wobei in der einen oder den mehreren Nachrichten die Durchführung von Berechnungen angefordert wird, und wobei der Rechner mittels der einen oder mehreren empfangenen Nachrichten angeforderten Berechnungen durchführt.

In einer weiteren Ausgestaltung des Verfahrens beinhaltet dieses ein Übermitteln der erzeugten Nachricht an den Rechenlastverteilungs-Rechner. Das Übermitteln kann dabei von dem oben in Zusammenhang mit dem Heizsystem und dem Rechner erwähnten Sender oder aber auch von der Steuereinrichtung durchgeführt werden.

Gemäß einem weiteren Ausführungsbeispiel des Verfahrens kann mindestens ein für den Betrieb des Heizsystems erforderlicher Parameter erfasst werden. Das Erfassen kann beispielsweise mittels in Zusammenhang mit dem Heizsystem oben erwähnten Steuervorrichtung erfolgen.

Gemäß einem noch weiteren Ausführungsbeispiel kann das Verfahren ferner ein Empfangen einer oder mehrerer Nachrichten von dem Rechenlastverteilungs-Rechner beinhalten, wobei in der einen oder den mehreren Nachrichten die Durchführung von Berechnungen angefordert wird.

In einem noch weiteren Ausführungsbeispiel kann das Verfahren ein Durchführen der mittels der einen oder mehreren empfangenen Nachrichten angeforderten Berechnungen mittels des Rechners aufweisen.

Gemäß verschiedenen Ausführungsbeispielen kann das Verfahren ferner ein Übertragen der bei der Durchführung der angeforderten Berechnungen durch den Rechner erzeugten Abwärme von dem Rechner an eine Wärmeverteilungseinrichtung des Heizsystems aufweisen.

Gemäß weiteren Ausführungsbeispielen können beim Verfahren Ergebnisse der von dem Rechner durchgeführten angeforderten Berechnungen dem Rechenlastverteilungs-Rechner bereitgestellt werden. Die Ergebnisse können dabei in gleicher Weise wie die erzeugte Nachricht an den Rechenlastverteilungs-Rechner oder an einen beliebigen anderen Rechner übermittelt werden. Die Übermittlung kann beispielsweise mittels des oben erwähnten Senders oder aber auch durch den Rechner selbst erfolgen.

Gemäß noch weiteren Ausführungsbeispielen des Verfahrens können die angeforderten Berechnungen derart durchgeführt werden, dass die dabei erzeugte Abwärme den Wärmebedarf deckt. Darunter ist zu verstehen, dass der die Berechnungen durchführende Rechner in Abhängigkeit von dem Wärmebedarf mehr oder weniger Rechenlast handzuhaben hat, da der Grad der Rechenlast, also die Anzahl der auf dem Rechner ablaufender Arbeitsprozesse, unmittelbar die Menge der erzeugten Abwärme beeinflusst.

In einer weiteren Ausgestaltung des Verfahrens erzeugt der Rechner eine Nachricht und sendet diese an den Rechenlastverteilungs-Rechner mit einer Information über einen Betriebszustand des Rechners.

Gemäß einer noch weiteren Ausgestaltung des Verfahrens wird der Betriebszustand des Rechners mittels Stoppens und/oder Hinzufügens und/oder Entnehmens von Rechenaufgaben angepasst.

Gemäß einem Aspekt des Verfahrens kann der Betriebszustand des Rechners ferner mittels Versetzens von einzelnen Rechenknoten in einen Energiesparmodus angepasst werden. Der Energiesparmodus kann dabei mehrere verschiedene Abstufungen aufweisen. So kann beispielsweise mindestens ein Prozessor in einen leistungsschwächeren Modus geschaltet werden, in dem er weniger Leistung aufnimmt. Es kann aber auch mindestens ein Prozessor ganz abgeschaltet werden. Überdies kann mindestens ein Rechenknoten in einen Schlafmodus bzw. Standby-Modus oder einen stromlosen Ruhezustand (Hibernation) versetzt werden. Dadurch wird vorteilhafterweise eine Möglichkeit zur Verfügung gestellt, den Rechner leistungsmäßig auf die angeforderten Rechenaufgaben hin abzustimmen und ihn so sehr energieeffizient zu betreiben.

Gemäß einer weiteren Ausführungsform kann das Verfahren aufweisen ein Ermitteln, ob der berechnete oder vorhergesagte Wärmebedarf durch einen Wärmespeicher gedeckt werden kann; ein Bereitstellen von Wärme aus dem Wärmespeicher zur Deckung des Wärmebedarfs, falls die im Wärmespeicher gespeicherte Wärme zur Deckung des Wärmebedarfs genügt oder andernfalls ein Erzeugen der Nachricht für den Rechenlastverteilungs-Rechner mit der Information über den Wärmebedarf des Heizsystems und/oder des Gebäudes aufweisen. In dieser Ausführungsform wird beispielsweise der Wärmebedarf des Heizsystems und/oder des Gebäudes zuerst mittels der im Wärmespeicher enthaltenen Wärme gedeckt. Es ist anzumerken, dass auch der nicht vollständig geladene Speicher genutzt werden kann, wenn Rechenleistung gefordert ist, ohne dass Wärmebedarf besteht.

Gemäß einer weiteren Ausführungsform kann das Verfahren ein Übertragen der bei der Durchführung der angeforderten Berechnungen durch den Rechner erzeugten Abwärme von dem Rechner an eine Wärmeverteilungseinrichtung des Heizsystems aufweisen, wobei ein Teil der an die Wärmeverteilungseinrichtung übertragenen Abwärme in dem Wärmespeicher gespeichert wird. Diese Ausführungsform ermöglicht es, gleichzeitig den Wärmespeicher zu laden und Wärme an die Wärmeverteilungseinrichtung des Heizsystems zu übertragen. Dieses kann bevorzugt auftreten, wenn die Abwärme des Rechners den aktuellen Wärmebedarf übersteigt und der Wärmespeicher, der sozusagen als Puffer fungiert, freie Speicherkapazität aufweist.

Im Weitern wird auch in verschiedenen Ausführungsbeispielen ein Rechenlastverteilungs-Rechner zum Verteilen und Koordinieren von Rechenaufgaben an Rechner eines Heizsystem-Netzwerks bereitgestellt, welches eine Vielzahl von Heizsystemen aufweist, wobei die Rechner Teil der Heizsysteme sind und die Heizsysteme Wärmeverteilungseinrichtungen zur Verteilung der von den Rechnern erzeugten Wärme aufweisen. Der Rechenlastverteilungs-Rechner weist einen Empfänger auf, der derart eingerichtet ist, dass er mindestens eine Nachricht von mindestens einem Rechner empfängt, wobei die mindestens eine Nachricht eine Information über einen Wärmebedarf eines Heizsystems und/oder eines Gebäudes und/oder einer Warmwasserbereitung enthält, und wobei der Rechenlastverteilungs-Rechner eingerichtet ist zum Erzeugen mindestens einer Nachricht an den mindestens einen Rechner, wobei mittels der mindestens einen Nachricht Berechnungen angefordert werden, wobei die angeforderten Berechnungen bestimmt werden unter Verwendung des von dem jeweiligen Rechner empfangenen Wärmebedarfs des Heizsystems, in dem der Rechner angeordnet ist.

Gemäß einem weiteren Ausführungsbeispiel kann der Rechenlastverteilungs-Rechner als ein einziger Rechner ausgebildet sein oder mehrere Rechner aufweisen. Anders ausgedrückt kann der Rechenlastverteilungs-Rechner mehrere Rechner aufweisen, auf welchen ein Rechenverteilungsalgorithmus implementiert ist und die Gesamtheit dieser Rechner einen dezentralen Rechenlastverteilungs-Rechner ausbildet.

Gemäß einem weiteren Ausführungsbeispiel kann der Rechenlastverteilungs-Rechner mehrere Rechner aufweisen, wobei zumindest ein Teil des Rechenlastverteilungs-Rechners ein Peer-to-Peer-Netzwerk bildet.

Gemäß einem noch weiteren Ausführungsbeispiel kann der Rechenlastverteilungs-Rechner eingerichtet sein zum Erzeugen mindestens einer Nachricht an den mindestens einen Rechner, wobei mittels der Nachrichten Berechnungen angefordert werden, wobei die angeforderten Berechnungen bestimmt werden unter Verwendung des von dem jeweiligen Rechner empfangenen Wärmebedarfs des Heizsystems und/oder des Gebäudes, in dem der Rechner angeordnet ist. Die vom Rechenlastverteilungs-Rechner erzeugte mindestens eine Nachricht kann beliebige Parameter und/oder Daten enthalten, die zur Durchführung der Berechnungen vorgesehen sind, beispielsweise Programmanweisungen, Datensätze, Skripte. Diese und weitere Arten von Daten können dabei in einer Nachricht enthalten sein oder können beliebig gruppiert werden und in mehreren Nachrichten enthalten sein.

In einem anderen Aspekt kann der Rechenlastverteilungs-Rechner derart eingerichtet sein, dass die angeforderten Berechnungen bestimmt werden in Abhängigkeit von beispielsweise dem Wärmebedarf des Heizsystems und/oder des Gebäudes und/oder einer Priorität der Berechnungen und/oder einer freien Rechenkapazität des Rechners und /oder einer Verfügbarkeit einer erforderlichen Infrastruktur und/oder einem Strombezugspreis und/oder einem Angebot an regenerativ erzeugtem Strom und/oder einem Ladezustand und/oder einer Verfügbarkeit eines Wärmespeichers des Heizsystems und/oder des Gebäudes. Bei jedem der soeben beispielsweise genannten Parameter kann es sich um einen Echtzeitwert handeln, der bei Bedarf ermittelt wird, oder aber auch um einen Wert, der in bestimmten (vorgegebenen) zeitlichen Abständen aktualisiert wird und somit einen Parameterwert aus der Vergangenheit darstellt. Ferner kann jeder der soeben beispielsweise genannten Parameter ein Schätz- bzw. ein Prognose- bzw. ein Interpolationswert sein, welcher auf Grundlage von entsprechenden Parametern aus der Vergangenheit ermittelt wird.

Gemäß einem weiteren Aspekt kann der der Rechenlastverteilungs-Rechner einen Sender aufweisen, der derart eingerichtet ist, dass er mindestens eine Nachricht an mindestens einen Rechner versendet, wobei mittels der Nachrichten Berechnungen angefordert werden.

Gemäß einem noch weiteren Aspekt kann der Rechenlastverteilungs-Rechner eingerichtet sein zum Versenden von Daten an die Rechner, auf Grundlage derer die Berechnungen ausgeführt werden. Die Daten können beispielsweise mittels des Senders versendet werden und beliebige Daten enthalten, die zur Durchführung der Berechnungen weiter erforderlich sind, beispielsweise Programme oder Teile davon, Programmanweisungen, Datensätze, Skripte.

Im Zusammenhang mit dem Rechenlastverteilungs-Rechner wird gemäß verschiedenen Ausführungsbeispielen ein Verfahren zum Betreiben eines Rechenlastverteilungs-Rechners bereitgestellt. Das Verfahren weist das Empfangen von mindestens einer Nachricht von mindestens einem Rechner eines Heizsystem-Netzwerks auf, welches eine Vielzahl von Heizsystemen aufweist, wobei die Rechner Teil der Heizsysteme sind und die Heizsysteme Wärmeverteilungseinrichtungen zur Verteilung der von den Rechnern erzeugten Wärme aufweisen, wobei die mindestens eine Nachricht eine Information über einen Wärmebedarf des Heizsystems und/oder eines Gebäudes und/oder einer Warmwasserbereitung enthält. Das Verfahren weist ferner das Erzeugen mindestens einer Nachricht an den mindestens einen Rechner auf, wobei mittels der mindestens einen Nachricht Berechnungen angefordert werden, wobei die angeforderten Berechnungen bestimmt werden unter Verwendung des von dem jeweiligen mindestens einen Rechner empfangenen Wärmebedarfs des Heizsystems, in dem der Rechner angeordnet ist.

Gemäß einem Ausführungsbeispiel weist das Verfahren ein Erzeugen mindestens einer Nachricht an den mindestens einen Rechner auf, wobei mittels der Nachrichten Berechnungen angefordert werden, wobei die angeforderten Berechnungen bestimmt werden unter Verwendung des von dem jeweiligen Rechner empfangenen Wärmebedarfs des Heizsystems und/oder des Gebäudes, in dem der Rechner angeordnet ist.

Ferner können bei dem Verfahren die angeforderten Berechnungen bestimmt werden in Abhängigkeit von dem Wärmebedarf des Heizsystems und/oder des Gebäudes und/oder einer Priorität der Rechenlastdaten und/oder einer freien Rechenkapazität des Rechners und /oder einer Verfügbarkeit einer erforderlichen Infrastruktur und/oder einem Strombezugspreis und/oder einem Angebot an regenerativ erzeugtem Strom und/oder einem Ladezustand und/oder einer Verfügbarkeit eines Wärmespeichers und/oder einer Wärmeabführkapazität. Unter der Wärmeabführkapazität ist dabei beispielsweise die Menge an Abwärme zu verstehen, welche vom Rechner abgeführt werden kann. Die Wärmeabführkapazität kann beispielsweise bei hohen Außentemperaturen, wenn zugleich der Wärmebedarf des Gebäudes niedrig ausfällt, vermindert sein und sie kann bei tiefen Außentemperaturen, wenn zugleich der Wärmebedarf des Gebäudes niedrig ausfällt, erhöht sein.

Gemäß einem anderen Ausführungsbeispiel kann das Verfahren Versenden von mindestens einer Nachricht an mindestens einen Rechner enthalten, wobei mittels der Nachricht Berechnungen angefordert werden.

Ausführungsbeispiele der Erfindung sind in den Figuren dargestellt und werden im Folgenden näher erläutert.

Es zeigen
- Figur 1: ein Heizsystemnetzwerk, das mittels des Internets mit einem zentralen Rechenlastverteilungs-Rechner gekoppelt ist, gemäß verschiedenen Ausführungsbeispielen;
- Figur 2: ein Heizsystemnetzwerk, das mittels des Internets mit einem dezentralen Rechenlastverteilungs-Rechner gekoppelt ist, gemäß verschiedenen Ausführungsbeispielen;
- Figur 3: ein Heizsystemnetzwerk, das an einen dezentralen auf die Heizsysteme verteilten Rechenlastverteilungs-Rechner gekoppelt ist, gemäß verschiedenen Ausführungsbeispielen;
- Figur 4A: ein Heizsystem ohne Wärmespeicher gemäß verschiedenen Ausführungsbeispielen;
- Figur 4B: eine Konfiguration eines Luftführungssystems eines Heizsystems ohne Wärmespeicher gemäß verschiedenen Ausführungsbeispielen;
- Figur 4C: eine weitere Konfiguration eines Luftführungssystems eines Heizsystems ohne Wärmespeicher gemäß verschiedenen Ausführungsbeispielen;
- Figur 5A: ein Heizsystem mit Wärmespeicher gemäß verschiedenen Ausführungsbeispielen;
- Figur 5B: eine Konfiguration eines Luftführungssystems eines Heizsystems mit Wärmespeicher gemäß verschiedenen Ausführungsbeispielen;
- Figur 5C: eine weitere Konfiguration eines Luftführungssystems eines Heizsystems mit Wärmespeicher gemäß verschiedenen Ausführungsbeispielen;
- Figur 6: ein Heizsystem gemäß verschiedenen Ausführungsbeispielen;
- Figur 7: einen schematischen Aufbau eines Rechners gemäß verschiedenen Ausführungsbeispielen;
- Figur 8: ein Diagramm, welches eine Interaktion der Komponenten des Heizsystem-Netzwerks gemäß verschiedenen Ausführungsbeispielen darstellt;
- Figur 9: ein Ablaufdiagramm eines Verfahrens zum Anpassen der Rechnerlast gemäß dem Wärmebedarf gemäß verschiedenen Ausführungsbeispielen;
- Figur 10: ein Sequenzdiagramm eines Verfahrens zum Anpassen der Rechnerlast am Rechner gemäß verschiedenen Ausführungsbeispielen;
- Figur 11: eine Zusammenstellung von Faktoren, die den Betriebszustand des Rechners beeinflussen, gemäß verschiedenen Ausführungsbeispielen;
- Figur 12: eine Darstellung einer Handhabung von Rechenaufgaben hoher Priorität gemäß verschiedenen Ausführungsbeispielen;
- Figur 13: ein Szenario zur Lastumverteilung zwischen Rechnern unterschiedlicher Heizsysteme gemäß verschiedenen Ausführungsbeispielen;
- Figur 14: ein Verfahren zur Optimierung des Betriebszustands des Rechners gemäß verschiedenen Ausführungsbeispielen;
- Figur 15: ein Verfahren zur Fernwartung des Rechners gemäß verschiedenen Ausführungsbeispielen;
- Figur 16: eine Darstellung eines Leistungsbereichs zur Deckung des Wärmebedarfs in einem Gebäude gemäß verschiedenen Ausführungsbeispielen;
- Figur 17: einen exemplarischen Tagesverlauf der solaren Leistung; und
- Figur 18: einen exemplarischen Verlauf der Strompreisentwicklung.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

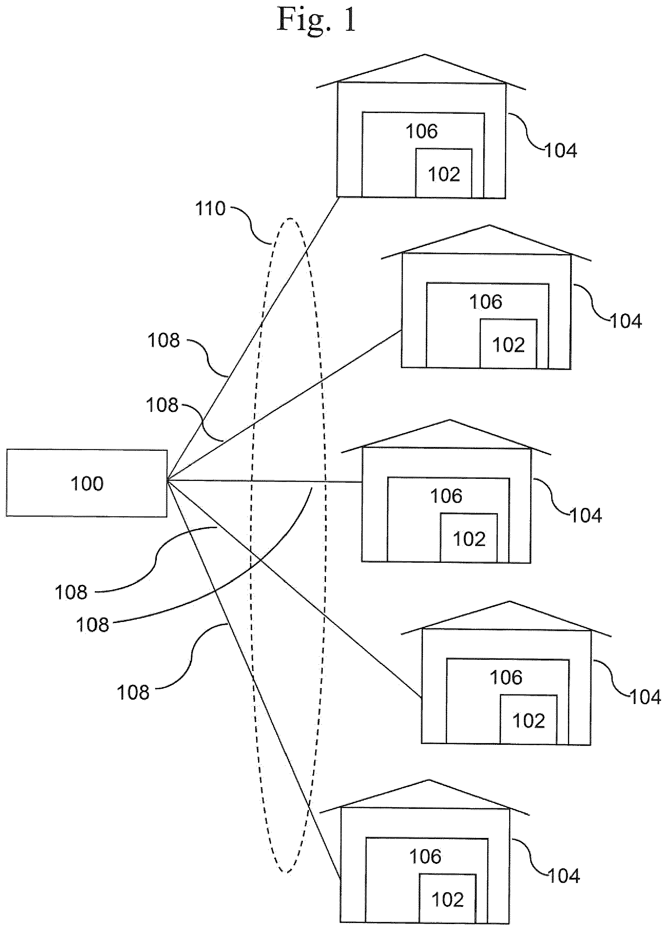

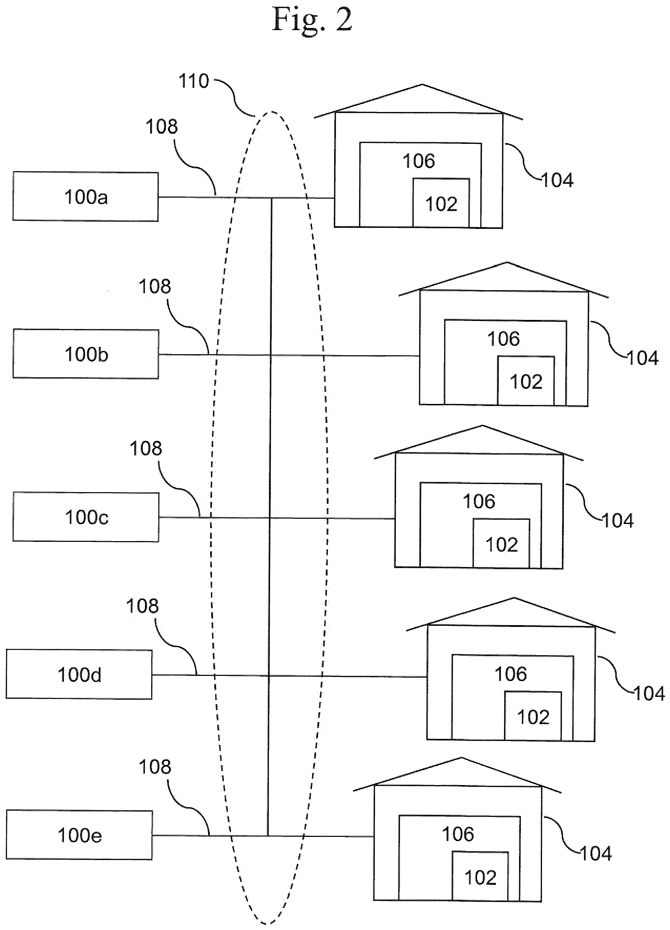

**Fig.1** zeigt einen Aufbau eines Heizsystem-Netzwerks gemäß verschiedenen Ausführungsbeispielen. Das Heizsystem-Netzwerk weist einen zentralen Rechenlastverteilungs-Rechner 100 auf, welcher mittels Verbindungen 108 mit einer Vielzahl von in Gebäuden 104 integrierten Heizsystemen 106 verbunden ist, wobei die einzelnen Verbindungen 108 stellvertretend für Pfade in einem Netzwerk, in diesem Beispiel dem Internet 110, zu sehen sind. Die Verbindungen 108 können als drahtgebundene und/oder drahtlose Verbindungen eingerichtet sein. Bei drahtgebundenen Verbindungen 108 kann es sich beispielsweise um gewöhnliche Telefonleitungen, welche in der Lage sind, einen Internetanschluss über Modem, ISDN (Integrated Services Digital Network - Digitalnetzwerk mit integrierten Diensten) und/oder DSL (Digital Subscriber Line - digitaler Teilnehmeranschluss) bereitzustellen und/oder um Glasfaserkabel und/oder um Fernsehkabel (wobei dann ein Kabel-Modem zur Informationseinkopplung und Auskopplung verwendet werden kann) handeln. Drahtlos eingerichtete Verbindungen 108 können beispielsweise über ein WLAN-Netzwerk (Wireless Local Area Network - drahtloses lokales Netzwerk) und/oder über ein Mobilfunknetzwerk, welches beispielsweise auf dem UMTS-Mobilfunkstandard (Universal Mobile Telecommunications System universelles Mobiltelekommunikationssystem) basiert oder welches die gesamte oder Teile der Kommunikation via Satellit herstellt, bereitgestellt werden. Die in Fig.2 Verbindungen 108 können dabei in ihrer Art beliebig kombiniert werden. Jedes Heizsystem 106 weist unter anderem einen Rechner 102 auf, der seine Abwärme an das Heizsystem 106 abgibt. Die Rechner 102 und der Rechenlastverteilungs-Rechner 100 sind dabei untereinander beispielsweise über ein Peer-to-Peer-Netzwerk und/oder über ein VPN-Netzwerk (Virtual Private Network - virtuelles Privatnetzwerk) zu einer Rechnerwolke (Cloud Computing) verbunden und stellen so eine Cloud-Computing-Infrastruktur bereit. Der zentrale Rechenlastverteilungs-Rechner (beispielsweise auch bezeichnet als Rechenlastverteilungsserver) 100 koordiniert dabei die Verteilung von Rechenaufgaben an die Rechner 106. Allgemein gesprochen kann das Heizsystem-Netzwerk einen Verbund von Rechnern aufweisen, die in einem Cloudverbund Rechenleistung und Heizleistung zur Verfügung stellen. Dabei agiert der Rechenlastverteilungs-Rechner als Steuer- und Kontrollinstanz, welche die Rechner in Abhängigkeit von relevanten Parametern wie beispielsweise Rechenanfrage, Wärmebedarf, die später genauer beschrieben werden, kontrollieren kann.

In **Fig.2** ist ein Aufbau eines Heizsystem-Netzwerks gemäß verschiedenen Ausführungsbeispielen dargestellt. Im Unterschied zu dem in **Fig.1** dargestellten Heizsystem-Netzwerk ist der Rechenlastverteilungs-Rechner 100 gemäß diesem Ausführungsbeispiel jedoch dezentral ausgebildet, d.h. der Rechenlastverteilungs-Rechner 100 weist mehrere Rechnereinheiten 100a bis 100e auf bzw. ist auf mehreren Rechnereinheiten 100a bis 100e implementiert, welche beispielsweise in verschiedenen Regionen aufgestellt sein können. Hier sind ebenfalls Rechner 102 der Heizsysteme 106 und die Gesamtheit der Rechenlastverteilungsrechner 100 über ein Peer-to-Peer-Netzwerk, beispielsweise mittels des Internets 110, zu einer Rechnerwolke untereinander verbunden und die Rechnereinheiten 100a bis 100e koordinieren die Verteilung von Rechenaufgaben an die Rechner 102. Mittels der Verbindungen 108 können also die Rechnereinheiten 100a bis 100e untereinander wie auch mit den Rechnern 102 kommunizieren. Durch die Gesamtheit der Rechnereinheiten 100a bis 100e, der Rechner 102 und der Verbindungen 108 wird eine Cloud-Computing-Infrastruktur bereitgestellt.

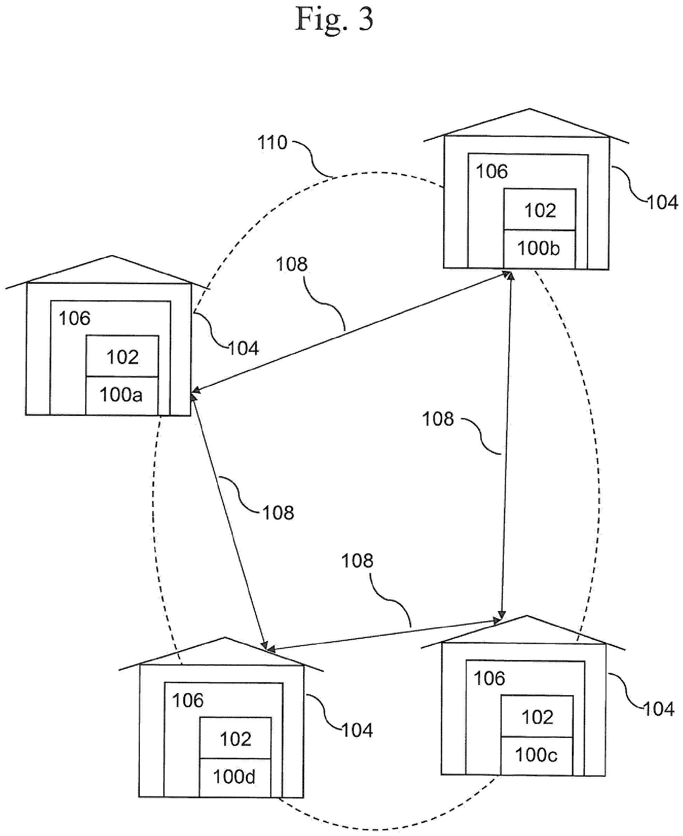

In **Fig.3** ist ein weiteres Beispiel eines Aufbaus eines Heizsystem-Netzwerks dargestellt, welches auf dem in **Fig.2** dargestellten Aufbau basiert. Hierbei ist der Rechenlastverteilungs-Rechner 100 ebenfalls dezentral ausgebildet, er ist jedoch auf die in den Gebäuden 104 stehenden Rechner 102 verteilt bzw. auf diesen implementiert. Abweichend von der Darstellung in der Fig.2 muss nicht auf jedem Rechner 102 eine dezentrale Rechenlastverteilungs-Rechnereinheit 100a bis 100d vorliegen. Bei diesem beispielhaften Aufbau sind alle Rechner 102 und alle Rechenlastverteilungs-Rechnereinheiten 100a bis 100d mittels eines Peer-to-Peer-Netzwerks über das Internet 110 zu einer Cloud-Umgebung verbunden.

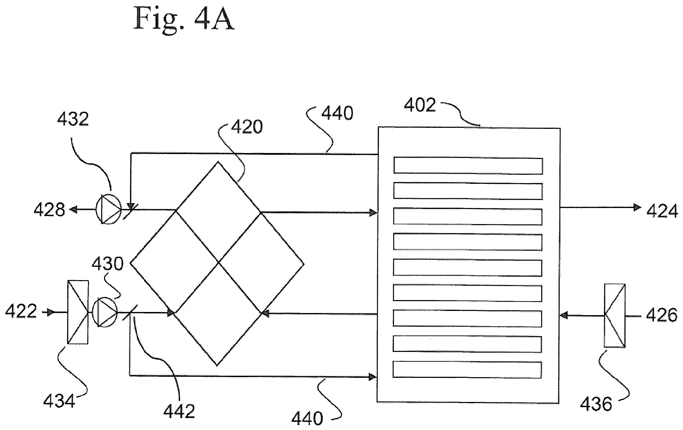

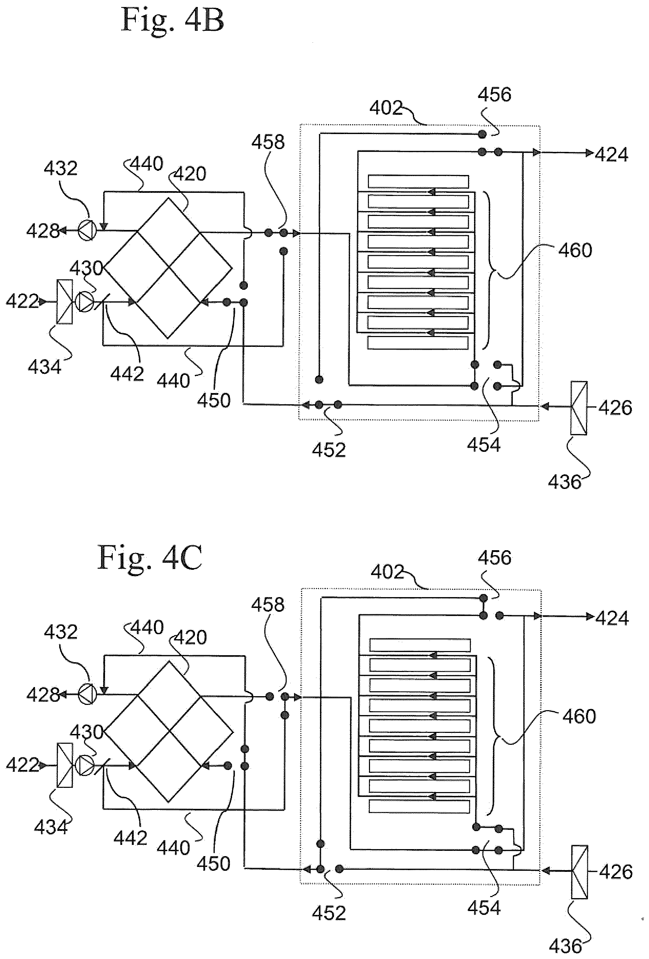

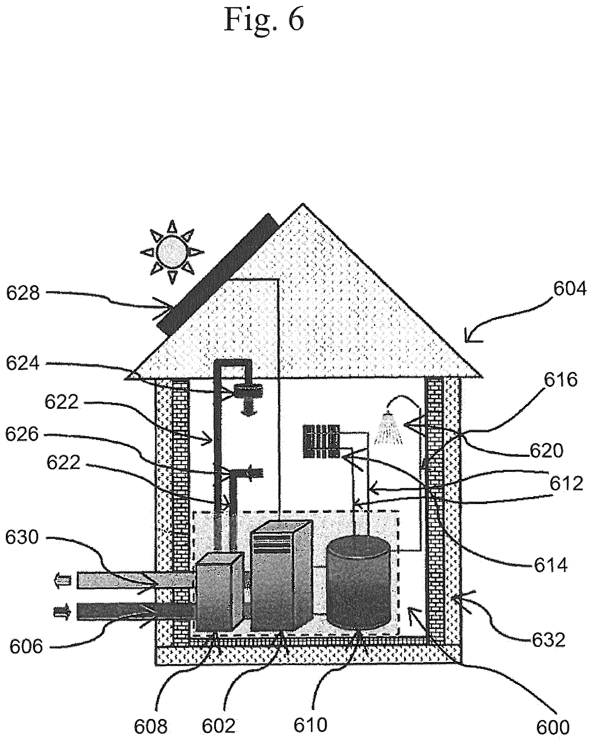

In **Fig.4** ist ein Ausführungsbeispiel eines Heizsystems gezeigt. Das Hauptaugenmerk liegt hierbei auf dem Rechner 402 als Wärmequelle und dem Übermitteln seiner Wärme an eine Wärmeverteilungseinrichtung eines Gebäudeheizungssystems. Eine detailliertere Beschreibung der Wärmeverteilungseinrichtung erfolgt in Zusammenhang mit Fig.6. Zur Kühlung des Rechners 402 wird von außen Frischluft 422 mittels eines Gebläses 430 angesaugt und gelangt in einen Filter 434. Stromabwärts des Filters 434 ist ein Umschalter 442 angeordnet, welcher die angesaugte Frischluft 422 entweder zu einen Bypass 440 oder zu einem Wärmetauscher 420 leitet. Der Bypass 440 ist mit dem Rechner 402 bzw. dem Rechnergehäuse verbunden. Der Wärmetauscher 420 ist ebenfalls mit dem Rechner 402 verbunden. Somit gelangt Frischluft 422 entweder über den Wärmetauscher 420 oder über den Bypass 440 in den Rechner 402. Der Rechner 402 ist mit einer Wärmeverteilungseinrichtung des Gebäudes verbunden (in der Figur nicht dargestellt), so dass von der Frischluft 422 aufgenommene Abwärme dem Heizsystem und/oder dem Gebäude als Zuluft 424 zugeführt werden kann. Eine weitere Verbindung zwischen dem Rechner 402 und der Wärmeverteilungseinrichtung ist dazu eingerichtet, Abluft 426 aus dem Heizsystem und/oder dem Gebäude über einen Filter 436 zurück zu dem Rechner 402 zu führen. Der Luftpfad der Abluft 426 ist im Rechner 402 vom Luftpfad der Frischluft 422 getrennt. Des weiteren weist der Rechner eine zweite Verbindung mit dem Wärmetauscher 420 auf, so dass aus dem Rechner 402 nach außen (damit ist die Außenumgebung des Gebäudes gemeint) abzuführende Luft ihre Restwärme mittels des Wärmetauschers 420 an in den Rechner 402 durch den Wärmetauscher 420 einströmende Frischluft 422 abgeben kann. Aus dem Rechner 402 nach außen abzuführende Luft kann diesen aber auch über einen weiteren Bypass 440 verlassen. Am Ausgang des Heizsystems, wo Luft als Fortluft 428 nach außen abgeleitet wird, ist ein weiteres Gebläse 432 befestigt, welches den Abtransport der Fortluft 428 erleichtern soll.

Für die Luftführung in dem soeben beschriebenen Ausführungsbeispiel des Heizsystems sind beispielsweise zwei unterschiedliche Modi vorgesehen. Es kann erforderlich sein, beispielsweise bei kalten Außentemperaturen, dass die von außen einströmende Frischluft 422 vorgewärmt werden muss. Dann erfolgt die Luftzuführung über den Wärmetauscher 420, in welchem eine Vorerwärmung der Frischluft 422 erfolgt. Die vorgewärmte Frischluft 422 gelangt dann in den Rechner und kühlt so dessen Komponenten. Durch die Abwärme des Rechners 402 wird die Frischluft 422 stark erwärmt und wird dann als Zuluft 424 der Wärmeverteilungseinrichtung (nicht dargestellt) zugeführt, so dass sie im Gebäude verteilt werden kann. Nachdem die Zuluft 424 so ihre Abwärme abgegeben hat, wird sie als Abluft 426 durch einen Bypass im Rechner (nicht dargestellt) in den Wärmetauscher 420 geführt und ist dann in der Lage die in das Heizsystem eintretende Frischluft 422 vorzuwärmen. Aus dem Wärmetauscher 420 wird die Abluft 426 mittels des Gebläses 432 als Fortluft 428 aus dem Heizsystem abgelassen.

Wenn die Frischluft 422 nicht vorgewärmt werden muss, beispielsweise bei wärmeren Außentemperaturen, so wird sie über den Bypass 438 in den Rechner 402 geführt, wo sie seine Abwärme aufnehmen kann. Die so erwärmte Luft wird als Zuluft 424 der Wärmeverteilungseinrichtung bereitgestellt und kann Wärme an das Gebäude bzw. die Wärmeverteilungseinrichtung abgegeben. Nach Abgabe der Abwärme gelangt die Luft als Abluft 426 in den Rechner und kann seine Abwärme erneut aufnehmen. Über den Bypass 440 wird die Abluft 426 dann vom Gebläse 432 angesaugt und verlässt sodann das Heizsystem.

Es ist auch für den Fall vorgesorgt, dass der Rechner gekühlt werden soll, jedoch von der Wärmeverteilungseinrichtung bzw. dem Gebäude keine Wärme aufgenommen werden kann, beispielsweise im Hochsommer. In diesem Fall wird Frischluft 422 nach Eintritt in den Rechner 402 durch den Bypass 438 und nach Aufnahme der Abwärme wieder aus dem Rechner 402 direkt über eine in der Fig.4 nicht dargestellte weitere Bypass-Struktur ausgestoßen, so dass die Abwärme des Rechners nicht an die Wärmeverteilungseinrichtung des Gebäudes abgegeben wird.

In Fig.4B und in Fig.4C ist jeweils das Ausführungsbeispiel eines Heizsystems gezeigt, welches in Fig.4A dargestellt ist, wobei die Luftführung im größeren Detail dargestellt ist. Es wird nachfolgend nur der Aspekt der Luftführung näher erläutert, da das in Fig.4B und in Fig.4C dargestellte Ausführungsbeispiel eines Heizsystems strukturell dem aus Fig.4A entspricht, so dass auch die Bauteile gleiche Bezugszeichen tragen. Wie in Fig.4A und in Fig.4B zu sehen ist, sind im Luftführungsweg mehrere Luftführungs-Umschaltelemente 450, 452, 454, 456, 458 angeordnet. Bei den Luftführungs-Umschaltelementen kann es sich um Abschnitte des Leitungssystems zum Leiten des Fluids, beispielsweise Luft, handeln, die geschlossen oder geöffnet werden können bzw. deren Anschluss dynamisch verändert werden kann. Die Schließung, Öffnung und/oder Veränderung des Anschlusses kann beispielsweise mittels Klappen und/oder beliebigen Ventilen, beispielsweise Luftführungsklappen und/oder Tellerventilen und/oder Kugelventilen, erfolgen. Je nach Stellung der Luftführungs-Umschaltelemente 450, 452, 454, 456, 458 kann der Luftführungsweg verändert werden und dadurch an die jeweiligen Bedürfnisse angepasst werden. Die Stellung der Luftführungs-Umschaltelemente 450, 452, 454, 456, 458 kann jederzeit verändert werden und sie kann beispielsweise von der Steuereinrichtung gesteuert werden. Im Folgenden werden zwei beispielhafte Stellungskonstellationen der Luftführungs-Umschaltelemente 450, 452, 454, 456, 458 beschrieben.

In dem in Fig.4B dargestellten Ausführungsbeispiel wird von der Außenumgebung des Gebäudes zugeführte Frischluft 422 durch den Wärmetauscher 420 zum Luftführungs-Umschaltelement 458 geleitet und dann zum Luftführungs-Umschaltelement 454 geführt. Das Luftführungs-Umschaltelement 454 ist dabei so eingestellt, dass es die Frischluft 422 in einen Abwärme-Aufnahmebereich 460 des Luftführungsweges leitet, wodurch die Frischluft 422 die Abwärme der Komponenten des Rechners 402 aufnehmen kann, wonach die erwärmte Luft als Zuluft 424 durch das Luftführungs-Umschaltelement 456 dem Wärmeverteilungssystem bzw. dem Gebäude zugeführt werden kann. Die Abluft 426 aus dem Heizsystem und/oder dem Gebäude wird durch die Luftführungs-Umschaltelement 454 und 452 unter Umgehung des Abwärme-Aufnahmebereiches 460 zum Wärmetauscher 420 geleitet und verlässt anschließend das Heizsystem und/oder das Gebäude über das Gebläse 432 als Fortluft 428. Diese Stellungskonstellation der Luftführungs-Umschaltelemente 450, 452, 454, 456, 458 entspricht dem bereits in Zusammenhang mit Fig.4A beschriebenen Fall, in dem eine Vorerwärmung der von außen einströmenden Frischluft 422 gewünscht ist, beispielsweise bei kalten Außentemperaturen. In dem in Fig.4C dargestellten Ausführungsbeispiel wird von der Außenumgebung des Gebäudes diesem zugeführte Frischluft 422 durch den Bypass 440, also unter Umgehung des Wärmetauschers 420, zum Luftführungs-Umschaltelement 458 geleitet und dann zum Luftführungs-Umschaltelement 454 geführt. Das Luftführungs-Umschaltelement 454 ist dabei so eingestellt, dass die Frischluft 422 unter Umgehung des Abwärme-Aufnahmebereiches 460 durch das entsprechend eingestelltes Luftführungs-Umschaltelement 456 als Zuluft 424 dem Wärmeverteilungssystem bzw. dem Gebäude zugeführt werden kann. Die Abluft 426 aus dem Heizsystem und/oder dem Gebäude wird durch das Luftführungs-Umschaltelement 454 zum Abwärme-Aufnahmebereich 460 geleitet, wonach sie durch entsprechende Stellungen der Luftführungs-Umschaltelemente 456, 452 und 450 zum Bypass 440 geleitet wird. Anschließend verlässt die Abluft 426 über das Gebläse 432 das Heizsystem und/oder das Gebäude als Fortluft 428. Diese Stellungskonstellation der Luftführungs-Umschaltelemente 450, 452, 454, 456, 458 entspricht dem bereits beschriebenen Fall, in dem eine Vorerwärmung der von der Außenumgebung des Gebäudes einströmenden Frischluft 422 nicht gewünscht ist, beispielsweise bei warmen Außentemperaturen.

Die soeben beschriebenen Stellungskonstellationen der Luftführungs-Umschaltelemente 450, 452, 454, 456, 458 stellen nur zwei beispielhafte Konstellationen dar. Es ist verständlich, dass viele weitere zweckmäßige Stellungskonstellationen mittels des ausgehend von Fig.4A in Fig.4B und in Fig.4C detaillierter dargestellten Luftführungssystems möglich sind. Als weitere Alternative kommt beispielsweise eine Stellungskonstellation in Frage, bei welcher die Luftführungs-Umschaltelemente 452, 454 und 456 im Rechner 402 die in Fig.4C gezeigte Stellungskonstellation aufweisen und die Luftführungs-Umschaltelemente 452 und 458 die in Fig.4B gezeigte Stellungskonstellation aufweisen. Dadurch kann erreicht werden, dass anstatt der Zuluft 424 die Abluft 426 erwärmt wird. Dies könnte beispielsweise nützlich sein, um ein Einfrieren des Wärmetauschers 420 bei Frischlufttemperaturen unter 0°C zu verhindern.

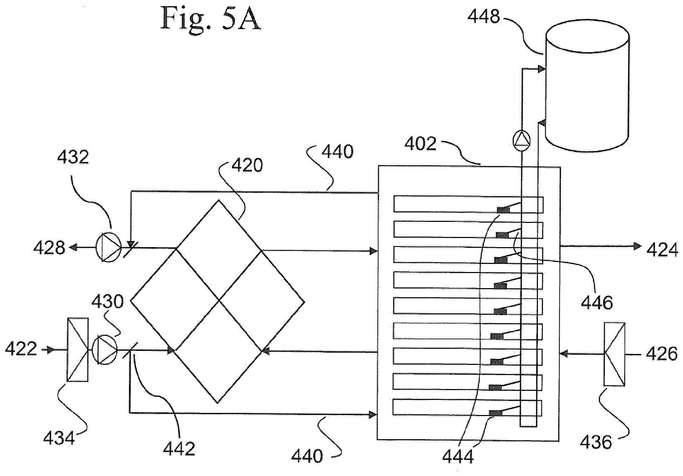

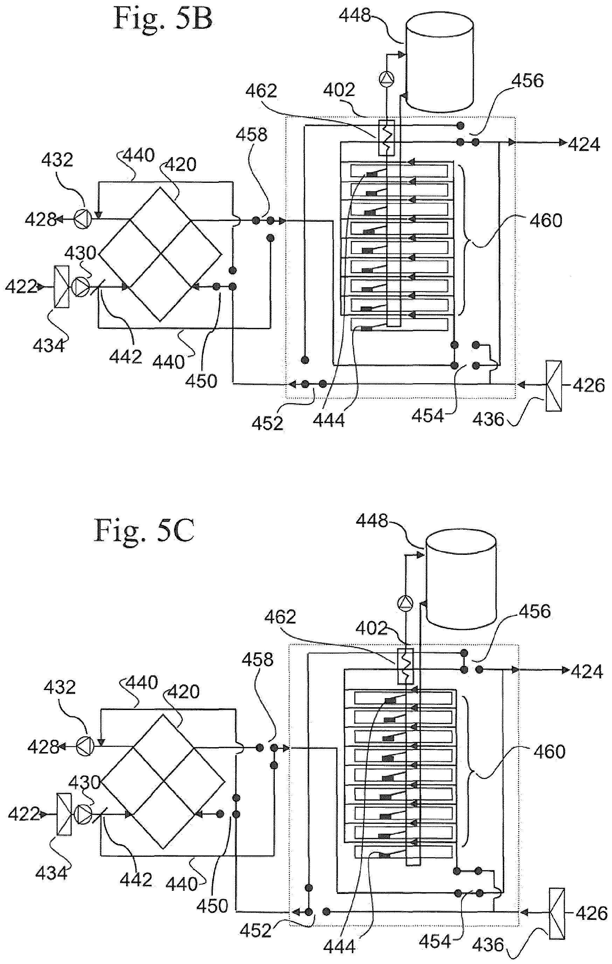

**Fig.5** zeigt ein abgewandeltes Ausführungsbeispiel des in **Fig.4** gezeigten Heizsystems. Die Luftführung erfolgt hier in Analogie zu dem in **Fig.4** gezeigten Ausführungsbeispiel. Es ist zusätzlich ein Wärmespeicher 448 vorgesehen, welcher mittels einer wärmetechnischen Kopplung 446 die Abwärme elektrischer Komponenten, beispielsweise der CPU (central processing unit - zentrale Recheneinheit) 444, aufnehmen kann. Die wärmetechnische Kopplung kann mittels eines festen und/oder flüssigen Wärmeübertragungsmediums erfolgen und ist nicht auf die Wärmeaufnahme aus der CPU 444 beschränkt, sondern kann auch Wärme aus anderen elektronischen Komponenten des Rechners 402 aufnehmen. Beispielsweise kann die wärmetechnische Kopplung ein Abführen der Wärme mittels Heatpipes (Wärmerohre) aufweisen. Der Wärmespeicher 448 kann beispielsweise für die Warmwasserversorgung im Gebäude vorgesehen sein und/oder Heizkörper im Gebäude mit Wärme versorgen.

In Analogie zu Fig.4B und Fig.4C ist in Fig.5B und in Fig.5C das Ausführungsbeispiel eines Heizsystems mit einem Wärmespeicher 448 gezeigt, welches in Fig.5A dargestellt ist, wobei die Luftführung im größeren Detail dargestellt ist. Die beiden in Fig.5B und in Fig.5C beispielhaft dargestellten Stellungskonfigurationen der Luftführungs-Umschaltelemente 450, 452, 454, 456, und 458 sind analog zu den in Fig.4B und 4C dargestellten Stellungskonfigurationen. Der einzige Unterschied besteht darin, dass ein Wärmespeicher 448 vorgesehen ist, welcher jedoch die Funktionsweise der Luftführungs-Umschaltelemente 450, 452, 454, 456, und 458 nicht ändert. Damit treffen sämtliche Aussagen bezüglich der in Fig.4B und Fig.4C dargestellten Stellungskonfigurationen des Luftführungssystems auch auf die Stellungskonfigurationen des Luftführungssystems gemäß Fig.5B und Fig.5C. Die in Fig. 5B und in Fig.5C dargestellten Ausführungsbeispiele eines Heizsystems können ferner einen optional vorhandenen und im Bedarf zuschaltbaren Wasser-Luft Wärmetauscher 462 aufweisen. Dieser kann zum Beispiel dann zugeschaltet werden, wenn der Speicher voll ist und der Rechner trotzdem weiter betrieben werden soll. Die Abwärme kann dann mittels des Wasser-Luft Wärmetauschers 462 an die Außenumgebung des Gebäudes abgeführt werden. Ein solcher Fall kann beispielsweise bei warmen Außentemperaturen auftreten.

Obwohl bei den in **Fig.4A****,** **Fig.4B, Fig.4C** und in **Fig.5A****,** **Fig.5B, Fig.5C** gezeigten Ausführungsbeispielen des Heizsystems nur der Rechner 402 als Wärmequelle dargestellt ist, kann das Heizsystem selbstverständlich weitere Wärmequellen aufweisen, insbesondere bei alten, schlecht isolierten Gebäuden, deren Wärmebedarf aus dem Rechnerbetrieb allein nicht gedeckt werden kann. So kann es zum Beispiel einen Heizkessel aufweisen, der mit Kohle oder Öl gefeuert wird, und/oder es kann an das Heizsystem eine Solaranlage, welche entweder direkt Strom (Photovoltaikanlage) oder Wärmeenergie (Solarthermieanlage) liefert und/oder eine Luft-Luft oder Luft-Wasser oder eine Wasser-Luft Wärmepumpe angeschlossen sein. Der Rechner 402 bzw. das Rechnergehäuse samt Luftzuführungs- und Luftabführungsanschlüssen hat in etwa eine Stellfläche einem Quadratmeter oder weniger.

In **Fig.6** ist eine schematische Übersicht eines Heizsystems 600 gemäß verschiedenen Ausführungsbeispielen gezeigt, das in ein Gebäude 604 integriert ist. Zur Kühlung des Rechners 602 wird von außerhalb des Gebäudes 604 Frischluft 606 angesaugt. Die Frischluft 606 kann dann durch den Wärmetauscher 608 geleitet werden und wird von dort in den Rechner 602 geleitet. Die Frischluft 606 kann aber auch wie in Fig.4 und Fig.5 dargestellt direkt in den Rechner 602 bzw. das Rechnergehäuse geleitet werden, wo sie die Abwärme des Rechners 602 aufnehmen kann. Über das Wärmeleitsystem wird die Abwärme des Rechners 602 im Gebäude 604 verteilt. Das Wärmeleitsystem weist Vorrichtungen wie beispielsweise Leitungen, Ventile, Durchflussregler und/oder weitere Wärmetauscher (in der Fig.6 sind nicht alle eben genannten Elemente explizit dargestellt), die dazu geeignet sind, Wärme von dem Rechner 602 und/oder aus dem an den Rechner 602 wärmetechnisch gekoppelten Wärmespeicher 610 (auch als Pufferspeicher bezeichnet) und/oder von einer beliebigen weiteren Wärmequelle, beispielsweise einer Photovoltaik- und/oder Solaranlage 628, im Gebäude 604 zu verteilen. In dem in Fig.6 gezeigten Aufbau sind das beispielsweise Leitungen bzw. Rohre 612, welche Heizkörper 614 im Gebäude mit Wärme versorgen, Leitungen bzw. Rohre 616, welche das Gebäude mit Warmwasser 620 versorgen sowie Leitungen 622, welche vom Rechner erwärmte Frischluft 606 als Zuluft 624 zur Temperierung der Räume im Gebäude 604 in diese leiten und Abluft 626 aus den Räumen des Gebäudes 604 abführen. In den Leitungen bzw. Rohren der Wärmeverteilungseinrichtung kann die Wärme im Gebäude beispielsweise mittels eines Gases und/oder einer Flüssigkeit und/oder eines festen Mediums erfolgen. Eine solche Wärmeverteilungseinrichtung kann bereits in herkömmlichen Gebäuden, wie beispielsweise Wohn- oder Bürogebäuden, vorhanden sein und kann zum Verteilen der Abwärme des Rechners 602 verwendet werden. Um eine vollständige Zirkulation von Frischluft im Rechner 602 und/oder im Gebäude 604 zu ermöglichen, sind ferner Leitungen vorgesehen, welche Luft aus dem Inneren des Gebäudes 604 und/oder aus dem Rechner 602 als Fortluft 630 an die Umgebung ablassen. Das in Fig.6 schematisch dargestellte Gebäude 604 kann eine hochwärmedämmende Außenhülle 632 aufweisen um die ihm zugeführte Wärme effizienter nutzen zu können.

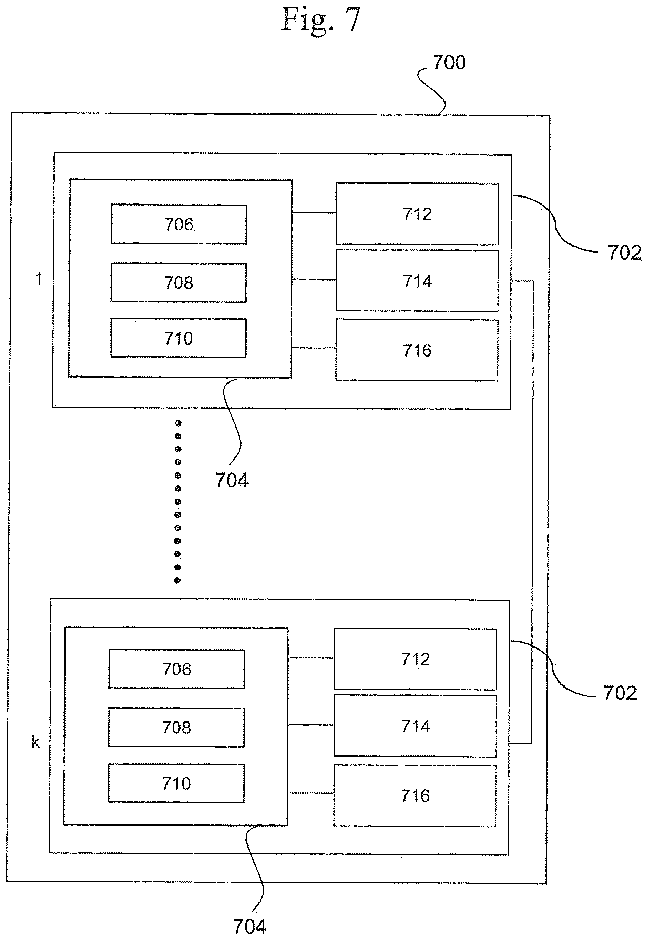

In **Fig.7** ist ein typischer Aufbau eines Rechners 700 schematisch dargestellt, wie er in einem Heizsystem gemäß verschiedener Ausführungsbeispiele zum Einsatz kommt. Ein solcher Rechner 700 weist üblicherweise einen gewöhnlichen Server-Rack auf, in den Rechenknoten 702 in Form von Einsteckplatinen eingesteckt werden können. Ein Rechenknoten ist dabei eine physikalische Ressource, zum Beispiel ein Computer. Ferner kann ein Rechner 700 Wärmeabführvorrichtungen aufweisen, beispielsweise in Form von Kühlkörpern und entsprechenden Be- und Entlüftungsvorrichtungen (nicht dargestellt), die zum Abführen der Wärme eingerichtet sind. Ein Rechner 700 gemäß verschiedenen Ausführungsbeispielen kann für gewöhnlich einen oder mehrere Rechenknoten 702 aufweisen. Ein Rechenknoten 702 weist ein Mainboard 704 mit mindestens einer CPU 706 mit mindestens einem Kern, entweder ohne oder mit deaktiviertem Grafikprozessor, oder mit mindestens einer GPU (graphics processing unit - Grafikverarbeitungseinheit) 708 und einem Arbeitsspeicher 710 auf. An das Mainboard 704 sind mindestens ein Speichermedium 712, beispielsweise in Form einer Festplatte, eines SSD (Solid State Drive - Festkörperlaufwerk) oder eines Flash-Laufwerks, mindestens ein Netzwerkadapter 714 und eine Stromversorgung 716 angeschlossen. Die Stromversorgung 716 ist in der Regel schaltbar ausgeführt und kann ferner mit einer unterbrechungsfreien Stromversorgung kombiniert werden, sodass kontrolliertes Ein- und Ausschalten des Rechenknotens 702 bei Stromausfall ermöglicht wird und/oder kurzzeitige Stromausfälle überbrückt werden können. Mittels des mindestens einen Netzwerkadapters 714 sind die Rechenknoten 702 mittels einer Weiche (Switch oder Router, nicht dargestellt) untereinander verbunden. Der Netzwerkadapter 714 stellt auch eine Verbindung nach draußen her, beispielsweise zum Rechenlastverteilungs-Rechner.

Ein exemplarischer Server im Jahre 2010 bestünde aus folgenden Komponenten: zehn Rechenknoten mit jeweils einem Mainboard mit einer CPU (z.B. Intel Xenon), die sechs Kerne aufweist, einem beispielsweise vier Gigabyte großen Arbeitsspeicher (allgemein einem beliebig großem Arbeitsspeicher) und einer Grafikkarte. Des Weiteren wären zwei Festplatten mit einer Kapazität von jeweils zwei Terrabyte und zwei Ethernetkarten an das Mainboard angeschlossen.

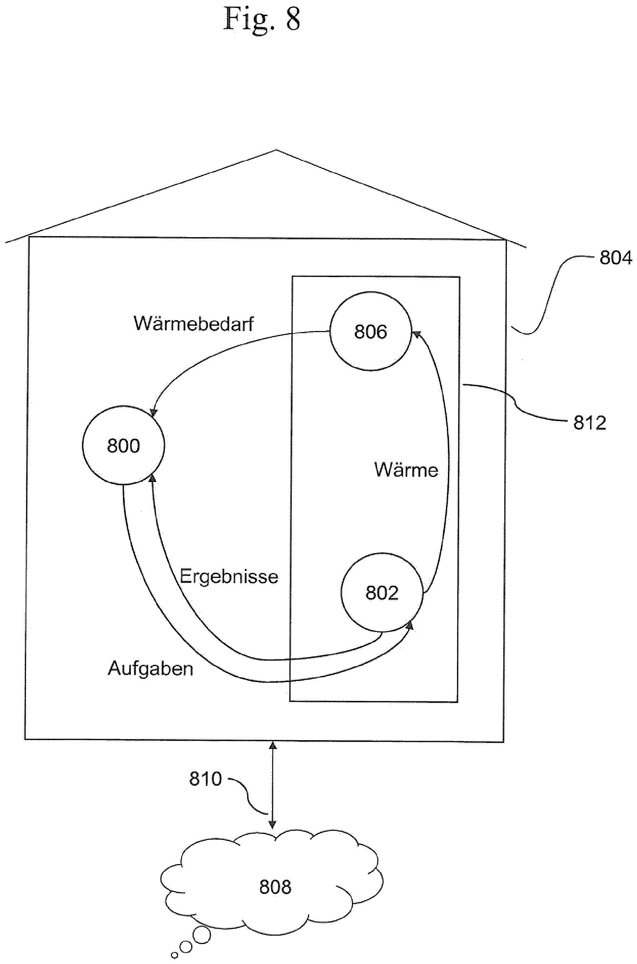

**Fig.8** veranschaulicht die Interaktion der einzelnen Komponenten eines Heizsystems 812 und des Rechenlastverteilungs-Rechners 800 untereinander. Bei diesem Ausführungsbeispiel des Heizsystems 812 ist die dezentrale Rechenlastverteilungs-Rechner 800 im Gebäude 804 angeordnet bzw. integriert. Ferner weist das Heizsystem zusätzlich zu dem Rechner 802 eine Steuereinrichtung 806 auf. In diesem Ausführungsbeispiel arbeitet die Steuereinrichtung 806 autonom und liegt als separate Einheit vor, die Steuereinrichtung 806 könnte aber auch ein Bestandteil des Rechners 802 sein oder auf diesem implementiert sein. Alternativ kann auch der Rechenlastverteilungs-Rechner 800 die Aufgaben der Steuereinrichtung 806 übernehmen. Die Steuervorrichtung 806 hat die Aufgabe, den Wärmebedarf des Gebäudes bzw. der Wärmeverteilungseinrichtung an den Rechenlastverteilungs-Rechner 800 zu melden. Diese Aufgabe könnte auch von dem Rechner 802 durchgeführt werden, wenn die Steuereinrichtung 806 mittels des Rechners 802 implementiert ist. Ausgehend von der Meldung über den Wärmebedarf des Gebäudes und/oder des Heizsystems fordert der Rechenlastverteilungs-Rechner 800 die Bearbeitung von Rechenaufgaben vom Rechner 802 an. Dabei wird durch die Zuteilung von Rechenaufgaben an den Rechner 802 seine Last so angepasst, dass aus der vom Rechner 802 an das Gebäude abgegebenen Abwärme der Wärmebedarf gedeckt werden kann. Ergebnisse der berechneten Rechenaufgaben werden dabei vom Rechner 802 dem Rechenlastverteilungs-Rechner 800 bereitgestellt. Der Rechner 802 übermittelt auch eine Information bezüglich der erzeugten Abwärmemenge an die Steuereinrichtung 806. Der Rechner des Heizsystems und der Rechenlastverteilungs-Rechner 800 sind dabei mittels eines Netzwerks 810, beispielsweise des Internets, an die Cloud (Rechnerwolke) 808 angeschlossen, über welche ihre Kommunikation mit weiteren Heizsystemen 812 und/oder Rechenlastverteilungs-Rechnern 800 dieser Art abgewickelt wird.

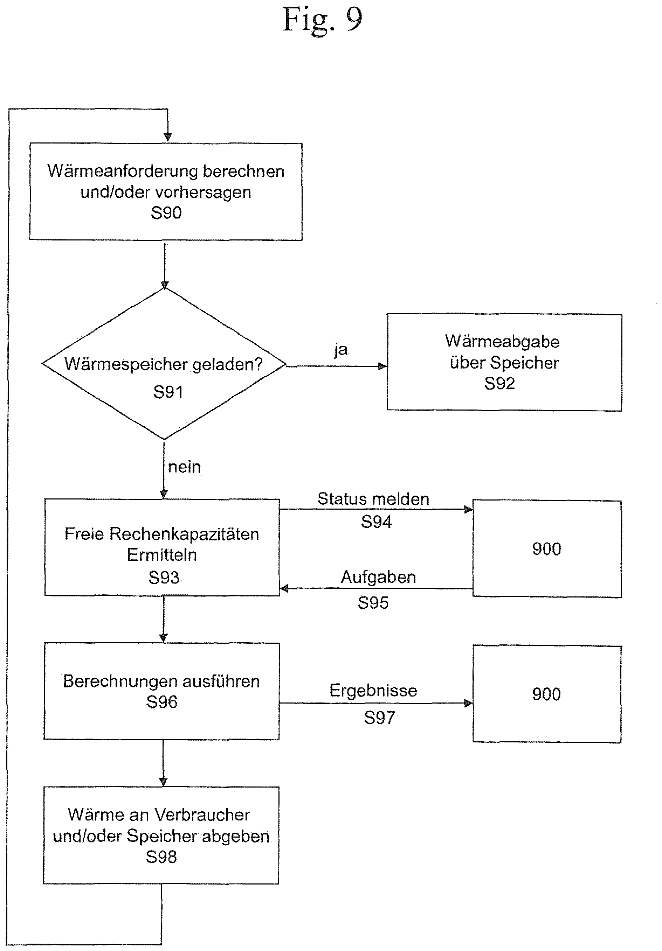

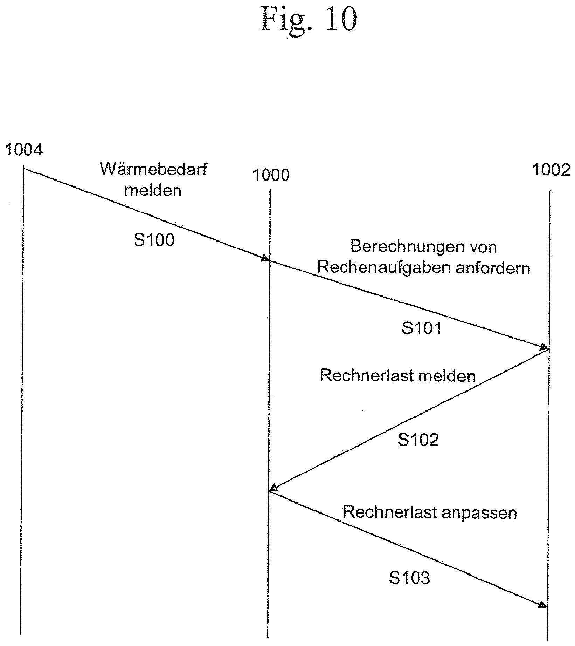

In **Fig.9** ist ein Ablaufdiagramm zur Erläuterung eines beispielhaften Verfahrens zum wärmemodulierten Steuern des Rechners dargestellt. In diesem Zusammenhang bedeutet wärmemoduliertes Steuern, dass die Leistungsaufnahme des Rechners und/oder der Umfang der Rechenaufgaben, deren Berechnung durch den Rechenlastverteilungs-Rechner vom Rechner angefordert wird, so angepasst wird/werden, dass die vom Rechner produzierte Abwärme den Wärmebedarf decken kann. Zunächst wird in Schritt S90 die Wärmeanforderung des Heizsystems und/oder des Gebäudes bestimmt, beispielsweise durch die Steuereinrichtung. Die Wärmeanforderung muss nicht auf Grundlage momentaner Zustandsparameter erfolgen (wie z.B. der momentanen Raumlufttemperatur in einem jeweiligen Raum des Gebäudes oder der momentanen Außentemperatur), sondern kann auch auf Grundlage von Zustandsparametern aus der Vergangenheit vorhergesagt und/oder interpoliert werden. Dann wird in Schritt S91 der Zustand des Wärmespeichers geprüft, d.h. es wird ermittelt, ob die darin gespeicherte Wärme den Wärmebedarf decken kann. Ist genügend Wärme im Wärmespeicher vorhanden, so wird in Schritt S92 Wärme aus dem Wärmespeicher entnommen und dem Heizsystem und/oder dem Gebäude bereitgestellt. Ist nicht genügend Wärme im Wärmespeicher vorhanden, dann wird in Schritt S93 die freie Rechnerkapazität ermittelt. Unter Rechnerkapazität ist im Sinne dieser Anmeldung die Verfügbarkeit von jeglicher Soft- und Hardware zur Bearbeitung von Rechenaufgaben und/oder die Auslastung im Rechner vorhandener Ressourcen, beispielsweise Prozessoren und Arbeitsspeicher, zu verstehen. Daraufhin erzeugt der Rechner eine Nachricht, wobei die Nachricht eine Information über einen Wärmebedarf des Heizsystems und/oder des Gebäudes bzw. dessen Status enthält. Die Nachricht wird in Schritt S94 an den Rechenlastverteilungs-Rechner 900 übermittelt. Die Nachricht kann ferner eine Information bezüglich der freien Rechenkapazität des Rechners enthalten, diese Information kann aber auch in einer separaten Nachricht enthalten sein, die zeitgleich oder nachfolgend an den Rechenlastverteilungs-Rechner 900 übermittelt wird. Ausgehend von den ihm übermittelten Informationen und unter Berücksichtigung weiterer Parameter (siehe dazu Fig.10) erzeugt der Rechenlastverteilungs-Rechner 900 mindestens eine Nachricht, die in Schritt S95 an den Rechner übermittelt wird, wobei mittels der mindestens einen Nachricht Berechnungen von Rechenaufgaben angefordert werden. Die mindestens eine Nachricht kann dabei weitere Daten enthalten, welche zum Abarbeiten der Rechenaufgaben erforderlich sind. Nach Erhalt der Anforderung von Rechenaufgaben und der möglicherweise weiteren dazu erforderlichen Daten führt der Rechner in Schritt S96 die angeforderten Rechenaufgaben aus und übermittelt die resultierenden Ergebnisse in Schritt S97 an den Rechenlastverteilungs-Rechner 900. Unter Ergebnissen sind nicht nur Ergebnisse von beispielsweise Berechnungs- oder Kompilierungsaufgaben gemeint, sondern auch Statusmeldungen bezüglich jeglichen ausgeführten Aufgaben oder durchgeführten Berechnungen, welche vom Rechenlastverteilungs-Rechner angefordert wurden. Die während der Bearbeitung erzeugte Abwärme wird dabei kontinuierlich in Schritt S98 an das Heizsystem und/oder das Gebäude abgegeben. Das dargestellte Ablaufdiagramm kann in einem beliebigen zeitlichen Abstand erneut ausgeführt werden. Wenn ermittelt wird, dass ein Wärmebedarf besteht, dann werden die eben beschriebenen Schritte durchgeführt. Wenn ermittelt wird, dass kein Wärmebedarf besteht, dann werden die weiteren Schritte nicht ausgeführt und das Ablaufdiagramm wird in einem beliebigen zeitlichen Abstand erneut durchlaufen.

Es sei drauf hingewiesen, dass das eben beschriebene Verfahren dahingehend abgeändert werden kann, dass während der Abgabe von Wärme in Schritt S98 der Wärmespeicher zusätzlich gleichzeitig geladen werden kann, falls beispielsweise in Schritt S91 ermittelt worden ist, dass der Wärmespeicher nicht vollständig geladen ist und somit Wärme aufnehmen kann. Alternativ kann auch die Abgabe von Wärme in Schritt S98 durch eine gleichzeitige oder nachgelagerte Abgabe von Wärme aus dem Wärmespeicher gemäß Schritt S92 unterstützt werden, falls beispielsweise durch die Abwärme des Rechners nicht der gesamte ermittele Wärmebedarf gedeckt werden kann.

Das in **Fig.9** dargestellte beispielhafte Verfahren kann ferner an ein Heizsystem angepasst werden, in dem kein Wärmespeicher vorhanden ist. In einem solchen Verfahren entfallen dann die Schritte S91 und S92, so dass nach Ermittlung der Wärmeanforderung in Schritt S90 sich Schritt S93 anschließt, in welchem die freie Rechnerkapazität ermittelt wird. Entsprechend kann dann in Schritt S98 die Abgabe der Wärme nur an das Heizsystem und/oder das Gebäude erfolgen, da kein Wärmespeicher vorhanden ist.

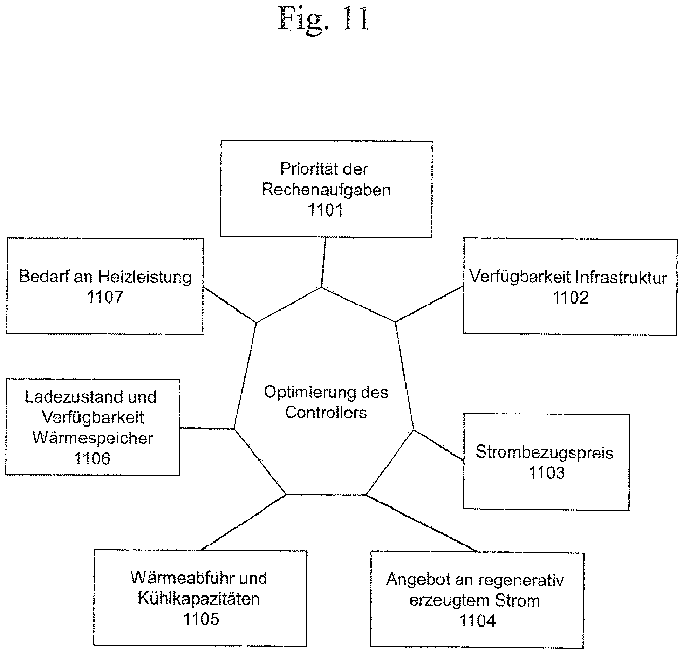

In **Fig.10** ist ein Sequenzdiagramm dargestellt, welches ein Ausführungsbeispiel eines Verfahrens zum Anpassen der Rechnerlast am Rechner 1002 veranschaulicht. Das Verfahren beginnt mit der Ermittlung des Wärmebedarfs des Heizsystems und/oder des Gebäudes durch die Steuereinrichtung 1004. In Schritt S100 wird eine Information über den Wärmebedarf des Heizsystems und/oder des Gebäudes an den Rechenlastverteilungs-Rechner 1000 übermittelt. Ausgehend von dieser Information sowie weiteren nachfolgend genauer erläuterten Parametern fordert in Schritt S101 der Rechenlastverteilungs-Rechner 1000 die Bearbeitung von Rechenaufgaben vom Rechner 1002 an und übermittelt an diesen möglicherweise weitere Daten, die zur Bearbeitung der Rechenaufgaben erforderlich sind. Während seines Betriebes meldet der Rechner 1002 in Schritt S102 seinen Betriebszustand an den Rechenlastverteilungs-Rechner 1000. Mögliche Angaben, die den Betriebszustand des Rechners 1002 beschreiben sind beispielsweise seine Auslastung bzw. seine Rechnerkapazität oder etwa die Temperatur der Prozessoren. Der Rechenlastverteilungs-Rechner 1000 kann dann ausgehend von der ihm übermittelten Meldung bezüglich des Betriebszustands des Rechners 1002 in Schritt S103 dessen Last anpassen, wobei weitere unabhängige Parameter berücksichtigt werden, die nachfolgend anhand der **Fig.11** genauer erläutert werden. Das Anpassen des Betriebszustands des Rechners 1002 kann beispielsweise über ein Stoppen und/oder Wiederaufnehmen und/oder Hinzufügen und/oder Entnehmens von Rechenaufgaben erfolgen. Es kann auch mindestens ein Rechenknoten in einen der Energiesparmodi versetzt werden oder es können Rechenknoten aus einem der Energiesparmodi wieder aktiviert werden.

In **Fig.11** sind beispielhaft Faktoren zusammengestellt, welche auf den Betriebszustand des Rechners Einfluss nehmen können. Wie bereits erläutert, wird die Last am Rechner primär wärmemoduliert, also derart angepasst, dass die Abwärme des Rechners den kurz-, mittel- und langfristigen Wärmebedarf des Heizsystems und/oder des Gebäudes decken kann, was einen 1107 der Faktoren darstellt, die bei der Verteilung der Rechenaufgaben durch den Rechenlastverteilungs-Rechner an die Rechner berücksichtigt werden. Beim Anpassen des Betriebszustands des Rechners 1100 bzw. und/oder der Verteilung von Rechenaufgaben an mindestens einen Rechner kann jedoch der Rechenlastverteilungs-Rechner weitere Faktoren berücksichtigen, beispielsweise: Priorität einer zu berechnenden Aufgabe 1101, wobei eine zeitabhängige Prioritätsveränderung erfolgen kann und Rechenaufgaben hoher Priorität unter Umständen ohne Rücksicht auf den Wärmebedarf verteilt werden mit der Anforderung der sofortigen Bearbeitung; Verfügbarkeit der Infrastruktur 1102, insbesondere im Hinblick auf Strom und Internet (beispielsweise tageszeitliche Schwankungen der Bandbreite); Strombezugspreis 1103, wobei sowohl momentane wie auch prognostizierte Werte berücksichtigt werden können; Angebot an regenerativer Energie, insbesondere unter Berücksichtigung der tageszeitlichen Schwankungen bei Solar- oder Windstrom; Wärmeabführmöglichkeiten und Kühlkapazitäten 1105, die insbesondere im Sommer bei heißen Temperaturen relevant sind; Ladezustand und Speicherfähigkeit des/der Wärmespeicher/s 1106 (z.B. Wasserspeicher oder thermische Bauteilaktivierung). Jeder der hier aufgeführten Faktoren kann bei seiner Ermittlung und/oder Berechnung auf aktuell abgefragten bzw. ermittelten Werten oder auf prognostizierten Werten gestützt sein. So kann beispielsweise beim Bestimmen des Strompreises der aktuelle Preis an der Strombörse ermittelt werden oder es kann auch ein prognostizierter Strompreis für die jeweilige Tageszeit aus entsprechenden Werten in der Vergangenheit abgeleitet werden.

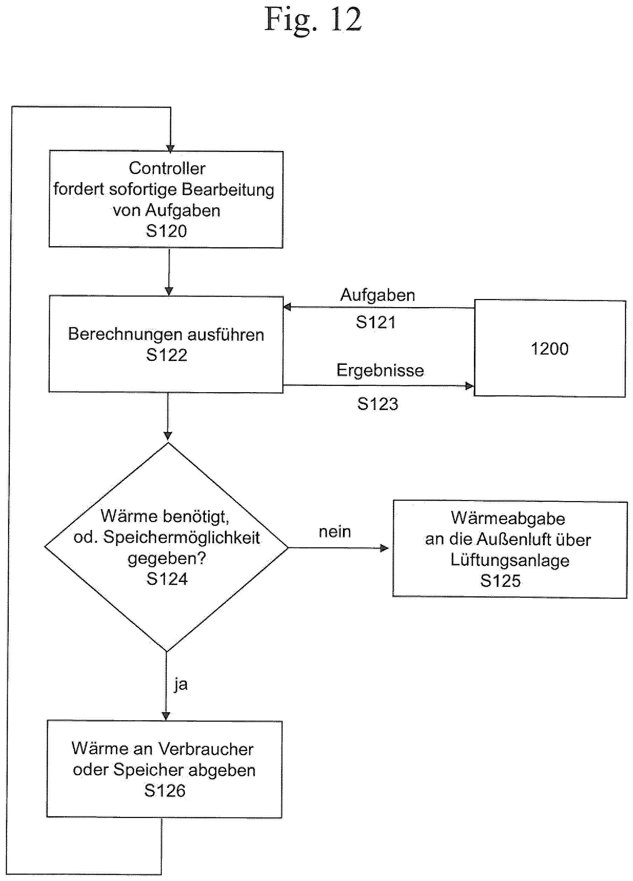

In **Fig.12** ist ein Ablaufdiagramm eines beispielhaften Verfahrens dargestellt, mittels dessen Aufgaben hoher Priorität und/oder Aufgaben, welche einer sofortigen Ausführung bedürfen, gehandhabt werden. Bei Aufgaben dieser Art, die schnellstmöglich auf die Rechner verteilt werden, kann aus wirtschaftlichen Gründen im Hinblick auf den Betrieb eines Rechnerverbunds, der einem Rechenzentrum äquivalent sein soll, nicht immer Rücksicht auf den aktuellen Wärmebedarf der Heizsysteme und/oder Gebäude genommen werden, deren Rechner an der Bearbeitung der Rechenaufgaben hoher Priorität beteiligt sind. Anders ausgedrückt kann auch der Fall eintreten, dass die Bearbeitung von Rechenaufgaben angefordert wird, obwohl das das Heizsystem und/oder das Gebäude keinen Wärmebedarf aufweist und/oder der Wärmespeicher voll aufgeladen ist. Ein solches Szenario wird nachfolgend genauer beschrieben. In Schritt S120 fordert der Rechenlastverteilungsserver 1200 die sofortige Bearbeitung von Rechenaufgaben an und übermittelt in Schritt S121 die Rechenaufgaben bzw. zu deren Abarbeitung erforderliche Daten an den Rechner. In Schritt S122 führt der Rechner die angeforderten Berechnungen aus und liefert in Schritt S123 Ergebnisse an den Rechenlastverteilungs-Rechner 1200. Während der Bearbeitung der Rechenaufgaben wird in Schritt S124 ermittelt, ob die erzeugte Abwärme an das Heizsystem und/oder das Gebäude, einschließlich eines möglicherweise vorhandenen Wärmespeichers, abgegeben werden kann. Falls zur Anfragezeit keine Wärme vom Heizsystem und/oder das Gebäude aufgenommen werden kann und/oder im Wärmespeicher (hierzu kann auch, falls vorhanden, ein Innen- Außenschwimmbad zählen) gespeichert werden kann, wird die entstandene Abwärme in Schritt S125 an die Außenluft abgegeben, beispielsweise über die entsprechend mittels einer Steuerung angesteuerte Bypassschaltung. Alternativ kann eine mittels flüssigem Medium betriebene außerhalb des Gebäudes installierte Kühleinheit Verwendung finden (nicht dargestellt), um die Abwärme abzuführen. Entsprechend wird in Schritt S126 mindestens ein Teil der Abwärme an das Gebäude oder dem Wärmespeicher abgegeben, falls Kapazitäten zur Wärmeaufnahme vorhanden sind.

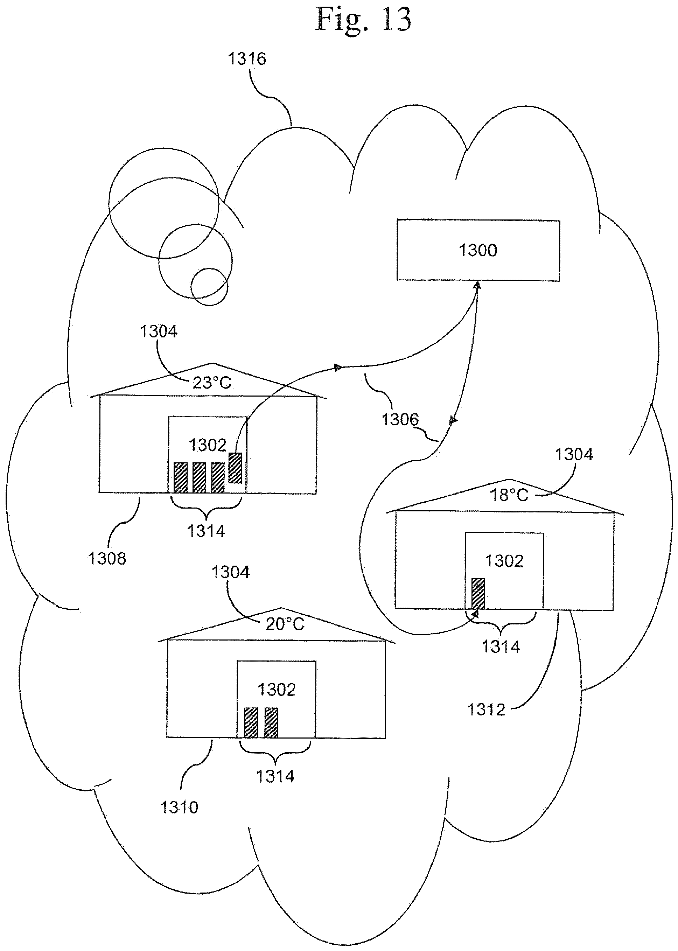

Wie bereits angeführt, wird von dem Heizsystem gemäß verschiedenen Ausführungsbeispielen ein effizientes und umweltfreundliches Heizen eines Gebäudes bereitgestellt. In **Fig.13** ist ein weiterer Aspekt des Heizsystem-Netzwerks verdeutlicht, nämlich durch den Wärmebedarf eines jeweiligen Gebäudes gesteuerte Lastumverteilung und/oder Lastverteilung. In dem Ausführungsbeispiel sind drei Gebäude 1308, 1310 und 1312 mit einem zentralen Rechenlastverteilungs-Rechner 1300 zu einer Cloud 1316 verbunden. In jedem der Gebäude befindet sich ein Rechner 1302, wobei die Anzahl der Balken 1314 die momentane Rechenlast des jeweiligen Rechners 1302 anzeigen soll. Ferner ist symbolisch an jedem Haus eine Innenraumtemperatur 1304 durch die Gradzahl angegeben. In diesem Fall erfolgt eine Umverteilung der Rechenlast, angedeutet durch den Pfeil 1306, von einem Rechner mit hoher Auslastung und/oder geringerer Wärmeanforderung des dazugehörigen Heizsystems und/oder Gebäudes, wie es beim Rechner 1302 in Gebäude 1308 mit einer Innenraumtemperatur 1304 von 23°C und einem stark ausgelasteten Rechner 1302 der Fall ist, auf einen Rechner mit kleiner Auslastung und/oder hoher Wärmeanforderung des dazugehörigen Heizsystems und/oder Gebäudes, wie dies beim Rechner 1302 in Gebäude 1312 mit einer Innenraumtemperatur 1304 von 18°C der Fall ist. Diese Umverteilung von Rechenaufgaben erfolgt beispielsweise für den Auftraggeber der Rechenaufgaben transparent (d.h. es ist für ihn nicht ersichtlich, dass die Rechenaufgaben in diesem Rechnerverbund verteilt bearbeitet werden), vorzugsweise in Echtzeit und ohne Anwendereingriff (beispielsweise in Form eines Umzugs einer virtuellen Maschine).

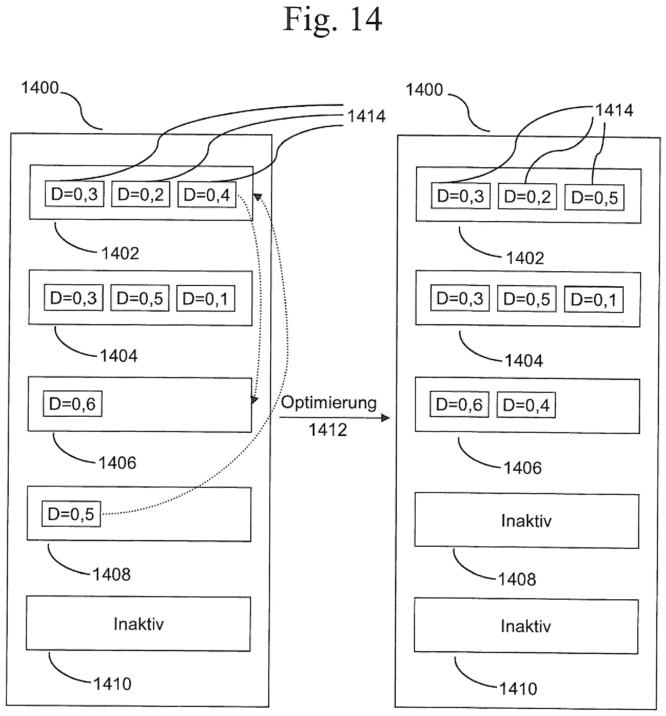

Ein weiterer Optimierungsprozess des Heizsystems kann auf Ebene des Rechners ablaufen und ist in **Fig.14** veranschaulicht. Dabei geht es um die Anpassung der Rechenlast einzelner Rechenknoten eines Rechners derart, dass die Leistung pro Watt optimiert wird. In dem Beispiel ist ein Rechner 1400 schematisch dargestellt, welcher mehrere Knoten 1402, 1404, 1406, 1408 und 1410 aufweist, von denen vor einer Optimierung 1412 die ersten vier Rechenknoten 1402, 1404, 1406, 1408 mit Rechenaufgaben 1414 beaufschlagt sind und der letzte Rechenknoten 1410 inaktiv ist. Die Rechenlast, mit welcher jede Rechenaufgabe einen entsprechenden Rechenknoten beansprucht, ist durch den Zahlenwert in dem jeweiligen die Rechenaufgabe 1414 repräsentierenden Kästchen gegeben. Die Summe der Rechenlasten in einem Rechenknoten liegt zwischen 0 und 1, wobei 0 Leerlauf und 1 volle Auslastung bedeutet. Dem Diagramm entnimmt man, dass vor der Optimierung 1412 der erste Knoten 1402 mit einer Auslastung von 0,9, der zweite Knoten 1404 mit einer Auslastung von 0,9, der dritte Knoten 1406 mit einer Auslastung von 0,6 und der vierte Knoten 1408 mit einer Auslastung von 0,5 arbeitet. Der Optimierungsvorgang 1412 hat nun zum Ziel, die Auslastung eines Rechenknotens zu maximieren, wodurch ggfs. ein oder mehrere Rechenknoten von Rechenaufgaben befreit werden und ausgeschaltet werden können. Durch die Verdichtung der Rechenaufgaben auf den Rechenknoten kann die Energie, die zu deren Betrieb eingesetzt wird, effizienter genutzt werden. In dem vorliegenden Beispiel erfolgt die Rechenlastverteilung (load balancing) durch Konsolidierung und Migration. Die Rechenaufgaben 1414 können also sinnvoll zusammengefasst werden und bei Bedarf zwischen den Rechenknoten mittels der Weichen (beispielsweise Layer 7 oder Layer 4 Switches, in der Fig.14 nicht dargestellt) verschoben werden. Falls mittels eines oder mehrerer der Rechenknoten 1402, 1404, 1406, 1408 und 1410 virtuelle Maschinen implementiert sind, können diese durch Live-Migration (Echtzeit-Migration) von einem Rechenknoten auf einen anderen Rechenknoten umgelagert werden, ohne dass die virtuellen Maschinen ausgeschaltet werden müssen. Nach einer durchgeführten Optimierung 1412 kann sich wie in Fig.14 dargestellt die vorteilhafte Situation ergeben, dass für die Berechnung derselben Rechenaufgaben 1414 eine kleinere Anzahl von Rechenknoten erforderlich ist. In dem gegebenen Beispiel liegen nun die Auslastungen der Rechenknoten 1402, 1404 und 1406 bei 1 und Rechenknoten 1408 nunmehr genau wie Rechenknoten 1410 inaktiv ist, sodass er heruntergefahren werden kann.

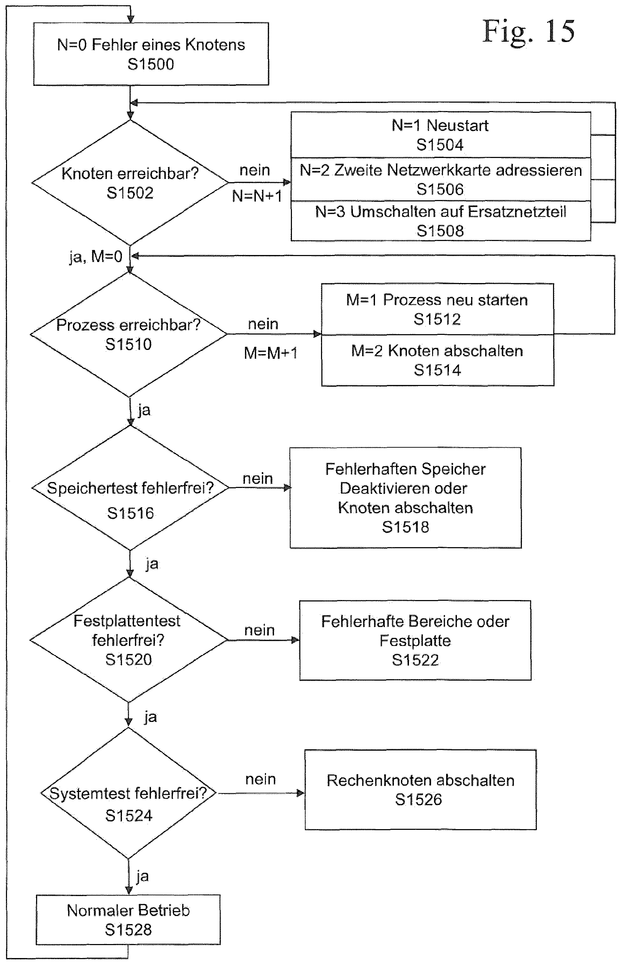

Bei einem dezentralen Rechenzentrum, der aus vielen zu einem Rechnerverbund bzw. zu einer Rechner-Cloud zusammengeschalteten Rechnern besteht, bedarf es besonderer Hardwaremodifikationen sowie Fehlerbehandlungsroutinen. Dadurch kann gewährleistet werden, dass die Wartung der Hardware nicht erschwert wird und die Wartungsintervalle niedrig gehalten werden können (z.B. ein Mal pro Jahr). Darüber hinaus können die Rechner mit einer unterbrechungsfreien Stromversorgung verbunden sein, die kürzere Ausfälle überbrückt und bei längeren Stromausfällen ein kontrolliertes Herunterfahren des Systems ermöglicht. Diesbezüglich ist in **Fig.15** in einem Ablaufdiagramm ein Ausführungsbeispiel eines Verfahrens zur Fernwartung des Rechners veranschaulicht. Startpunkt des Verfahrens ist in Schritt S1500 der Auftritt eines möglicherweise permanenten Fehlers in einem Rechenknoten (N=0). Dieser äußert sich beispielsweise in einer fehlerhaften oder fehlenden Übermittlung von Berechnungsergebnissen, beispielsweise an den Rechenlastverteilungs-Rechner. Zunächst wird überprüft, ob die Stromversorgung und Netzwerkverbindung sichergestellt ist (nicht dargestellt). In Schritt S1502 wird daraufhin geprüft, ob der Rechenknoten erreichbar ist. Ist der Rechenknoten nicht erreichbar (N=1), so wird in Schritt S1504 ein Neustart des Rechenknotens ausgeführt und es wird erneut überprüft, ob der Rechenknoten erreichbar ist (Schritt S1502). Ist der Rechenknoten weiterhin nicht erreichbar (N=2), so wird in Schritt 1406 versucht über den zweiten Netzwerkadapter eine Verbindung zu dem betroffenen Rechenknoten aufzubauen und es wird nachfolgend erneut überprüft, ob der Rechenknoten erreichbar ist (Schritt S1502). Ist der Rechenknoten weiterhin nicht erreichbar bzw. ansprechbar(N=3), so wird der betroffene Rechenknoten auf ein anderes Netzteil umgeschaltet und es wird erneut überprüft, ob der Rechenknoten erreichbar ist (Schritt S1502). Ist der Rechnerknoten weiterhin nicht erreichbar (N=4), so wird er abgeschaltet und beim nächsten Wartungsdienst ausgetauscht oder repariert werden. Falls der Rechenknoten nach Durchführen eines der Schritte S1504, S1506 oder S1508 und erneuter Überprüfung (S1502) erreichbar ist, wird in Schritt S1510 überprüft, ob der (oder die) mit den Rechenaufgaben assoziierte(n) Prozess(e) erreichbar ist (sind) (M=0). Ist das nicht der Fall (M=1), so wird der Prozess neu gestartet und es wird erneut überprüft, ob der Prozess erreichbar ist (S1510). Ist das nicht der Fall (M=2), so wird der betroffene Knoten abgeschaltet und beim nächsten Wartungsdienst ausgetauscht oder repariert werden. Ist der Prozess nach Durchführen eines der Schritte S1512 oder S1514 und erneuter Überprüfung (S1510) erreichbar, so wird in Schritt S1516 ein Arbeitsspeichertest des betroffenen Rechenknotens durchgeführt. Wird ein Speicherfehler im Arbeitsspeicher festgestellt, so wird in Schritt S1518 versucht, den fehlerhaften Speicherbereich, sofern technisch möglich, zu deaktivieren oder es muss gegebenenfalls der betroffene Rechenknoten abgeschaltet werden. Schließt der Arbeitsspeichertest fehlerfrei ab, so werden in Schritt S1520 die nichtflüchtigen Speichermedien (z.B. Festplatten) überprüft. Treten Fehler bei der Überprüfung der nichtflüchtigen Speichermedien auf, so wird in Schritt S1522 versucht die fehlerhaften Teile, sofern technisch möglich zu deaktivieren. Alternativ kann auch das betroffene Speichermedium ganz deaktiviert werden und ersatzweise ein Speichermedium mit denselben darauf redundant abgespeicherten Daten verwendet werden. In einem solchen Fall kann es sein, dass eine Replizierung dieser Daten auf ein weiteres Speichermedium erforderlich wird, um Redundanz wiederherzustellen. Verläuft hingegen die Überprüfung der nichtflüchtigen Speichermedien (S1520) fehlerfrei, so wird in Schritt S1524 ein Systemtest durchgeführt. Treten bei diesem Systemtest Fehler auf, die nicht mittels Fernwartung behoben werden können, dann werden in Schritt S1526 Maßnahmen der Datenrettung eingeleitet und der betroffene Knoten wird abgeschaltet und beim nächsten Wartungstermin repariert oder ausgetauscht. Verläuft hingegen der Systemtest (S1524) fehlerfrei, so kann der Rechenknoten in Schritt S1528 in einen normalen Betrieb überführt werden.

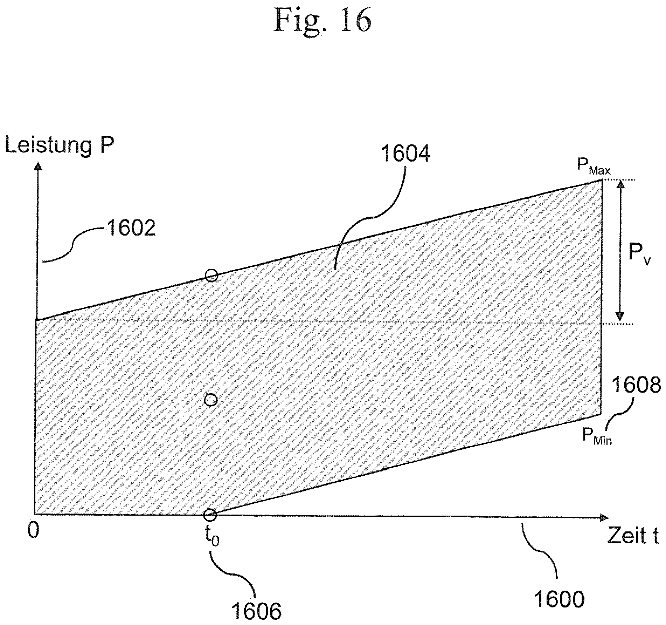

In Fig.16 ist der Zusammenhang zwischen einem Leistungsbereich zur Deckung des Wärmebedarfs und dem Betrieb des Rechners veranschaulicht. Auf der x-Achse 1600 des Diagramms ist eine Zeit aufgetragen, auf der y-Achse 1602 ist eine Leistung aufgetragen. Der Leistungsbereich zur Deckung des Wärmebedarfs ist abhängig vom aktuellen und zu erwartenden Wärmebedarf und wird in dem Diagramm durch die schraffierte Fläche 1604 dargestellt. Er kann von einer Reihe von Faktoren abhängig sein (z. B. Außentemperatur).Der in dem Diagramm dargestellte Verlauf zeigt eine Momentaufnahme des gegenwärtigen Leistungsbedarfs und wird anhand von Messwerten und Prognosen regelmäßig aktualisiert. Der Rechner kann zunächst im Leistungsbereich 0 bis P_{Max} betrieben werden. Bis zum Zeitpunkt tₒ 1606 ist es möglich, den Rechner ausgeschaltet zu belassen. Spätestens ab dem Zeitpunkt to 1606 ist der Rechner zu betreiben. Die Leistung kann im schraffierten Bereich variieren, solange sie nicht unter den Wert P_{Min} 1608 fällt.

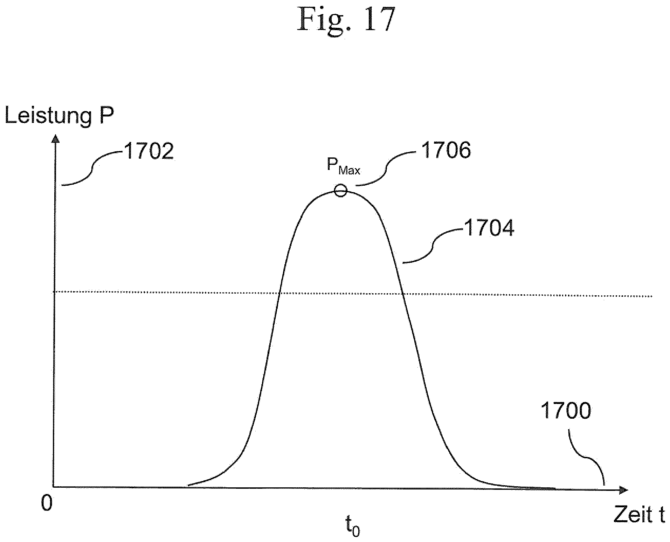

Zusätzlich zu dem Rechner als Wärmequelle können auch weitere Wärmequellen an das Heizsystem des Gebäudes angeschlossen sein. Beispielsweise kann eine Solaranlage an das Heizsystem angeschlossen werden. Unter einer Solaranlage ist hierbei eine Vorrichtung gemeint, die Sonnenenergie in elektrische Energie (Photovoltaik) oder in Wärmeenergie umwandelt. Um eine effiziente Kopplung der Solaranlage und des Rechners an das Heizsystem zu verwirklichen, ist die über den Tagesverlauf schwankende Verfügbarkeit von Solarenergie bei der Abschätzung der vom Rechner zu liefernden Abwärme zu berücksichtigen. In **Fig.17** ist ein beispielhafter Tagesverlauf der Sonnenleistung (wolkenloser sonniger Tag) dargestellt. Auf der x-Achse 1700 ist die Zeit aufgetragen, wobei der im Diagramm sichtbare Bereich einen Tagesverlauf von 24 Stunden abdecken soll, auf der y-Achse 1702 die solare Leistung aufgetragen. Der Verlauf der solaren Leistung 1704 weist eine glockenähnliche Form auf, wobei er zur Mittagszeit (t₀) seinen maximalen Wert 1706 erreicht (Pₘₐₓ).

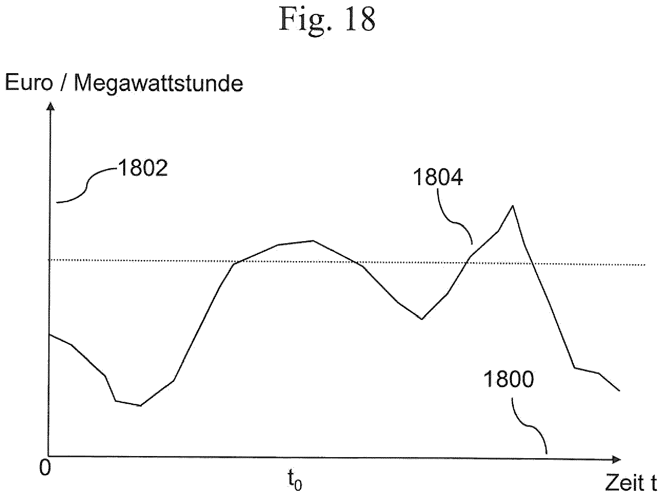

Wie bereits angeführt, ist der Strompreis einer der möglichen Faktoren, die bei der Verteilung der Rechenaufgaben an die Rechner vom Rechenlastverteilungs-Rechner berücksichtigt werden. In **Fig.18** ist ein exemplarischer Verlauf des Strompreises an der Frankfurter Strombörse EEX dargestellt. Die x-Achse 1800 des Graphen stellt die Zeit dar, die y-Achse 1802 den Preis in Euro pro Energieeinheit in Megawattstunden. An diesem exemplarischen Preisverlauf 1804 lässt sich ablesen, dass der Strompreis an den frühen Morgenstunden deutlich günstiger ist. Er erreicht seinen ersten Höhepunkt gegen Mittag (ca. 12Uhr) und einen weiteren Höhepunkt am Abend gegen 20 Uhr. Mit der Einführung neuen Generation der Stromzähler (Smart Meter) (bei Neubauten ab 2010 Pflicht) wird die zeitabhängige Erfassung und Abrechnung von Strombezügen möglich. Dadurch wird es beispielsweise möglich, den Rechner zu Zeiten günstiger Strompreise zu betreiben und dessen Abwärme im Wärmespeicher zu puffern, so dass zu Zeiten hoher Strompreise weniger Rechenleistung erforderlich wird, um den Wärmebedarf des Heizsystems und/oder des Gebäudes zu Decken.

Nachfolgend wird eine kurze Zusammenfassung der Ausgangsproblematik und des Lösungsansatzes, welcher letztendlich zum Heizsystem gemäß verschiedener Ausführungsbeispiele führt, gegeben werden.

Deutsche Rechenzentren produzieren schon heute in einem Jahr so viel Abwärme, dass man damit alle Neubauten bundesweit zwölf Jahre heizen könnte (Stand: 2011). Es wird erwartet, dass einerseits der Energieverbrauch von Rechenzentren, trotz des zunehmenden Einsatzes von energieeffizienten Rechnern, weiterhin stark wachsen wird. Andererseits wird der Energieverbrauch von Neubauten getrieben durch neue Gesetzgebungen weiterhin stark sinken. Daher wird erwartet, dass in Zukunft ein Großteil der Neubauten und auch sanierten Häuser im Prinzip durch die Abwärme von Rechenzentren gedeckt werden könnte.

Die Erfindung beruht auf der wärmetechnischen Kopplung eines Rechners, auch bezeichnet als Rechnerheizung oder IT-Cloud-Heizer mit einer oder mehrerer Wärmeverteilungseinrichtungen zur Beheizung von Gebäuden, beispielsweise Wohngebäuden und/oder Bürogebäuden und/oder kommerziellen und/oder öffentlichen Einrichtungen. Bei dieser Kopplung wird die zum Betrieb der Rechner notwendige Kühlung genutzt, um den Wärmebedarf und gegebenenfalls den Warmwasserbedarf eines Gebäudes und/oder einer Wohneinheit gänzlich zu decken.

Wie eingangs erwähnt, gibt es bereits Ansätze und Umsetzungen des "Green computing", bei denen die Abwärme von Rechenzentren für nahegelegene Gebäude zur Teiltemperierung genutzt wird. Diese Ansätze sind noch in den Anfängen der Entwicklung. Beispielsweise sei hier der IBM hotwater supercomputer an der ETH Zürich genannt, bei dem die Abwärme der Server über einen wasserbasierten Kühlkreislauf dem Heizkreislauf zugeführt wird. Dieses Rechenzentrum wirkt somit heizungsunterstützend. Die Server werden dort "klassisch" rund um die Uhr betrieben, d.h. es gibt keine wärmegeführte Modulation der Rechner. Im Gegensatz dazu produziert die Mehrzahl der Rechenzentren deutlich mehr Abwärme, als vor Ort genutzt werden kann.
Die Abwärme in Rechenzentren ist aufgrund des niedrigen Temperaturniveaus in wesentlichen Teilen nicht für andere Zwecke nutzbar und muss mittels aufwendiger Kühltechnik und unter zusätzlichem energetischen Aufwand abtransportiert werden.

Heizungssysteme in Häusern setzen primäre (meist fossile Brennstoffe) und sekundäre Energieträger (Strom) in Wärme um. Eine höherwertige Nutzung des Energieträgers in Form von Rechenleistung findet in der Regel nicht statt.

Das Problem der Abwärmenutzung von Rechenzentren ist der Transport der Abwärme von den Rechenzentren zu den Häusern. Es müsste mit hohen Kapitalkosten ein Fernwärmenetz gebaut werden, das nie flächendeckend sein könnte. Die hier beschriebenen Heizsysteme wird ein reziproker Ansatz gewählt, bei welchem die Rechenaufgaben auf Häuser verteilt werden, so dass die Wärme dort entsteht, wo sie gebraucht wird. Weiterhin kann im Zuge dieses Ansatzes auch regenerative Energie, beispielsweise Solarstrom, dort verbraucht werden, wo sie produziert wird. Diese Verteilung von Rechenaufgaben wird auch durch den zunehmenden Einsatz von Cloud computing und den Ausbau der Hochgeschwindigkeitsnetze ermöglicht. Das hierbei verfolgte Ziel ist es, Rechner von Rechenzentren auf Niedrigenergiehäuser zu verteilen und mit der ohnehin entstehenden Abwärme die konventionelle Heizung vollständig zu ersetzen. Um den Heizbedarf eines Passivhauses mit 160m² beheizter Fläche zu decken, wären zum Beispiel nur acht Recheneinheiten mit je 200 Watt nötig (Stand: 2011).

Cloud Computing ist primär der Ansatz, abstrahierte IT-Infrastrukturen (z.B. Rechenkapazität, Datenspeicher, fertige Software- und Programmierumgebungen) als Service dynamisch an den Bedarf angepasst über ein Netzwerk zur Verfügung zu stellen. Die Abrechnung erfolgt dabei nutzungsabhängig, da nur tatsächlich genutzte Dienste bezahlt werden müssen. Ein weiterer zentraler Punkt des Konzepts ist, dass die Bereitstellung basierend auf der Kombination aus virtualisierten Rechenzentren und modernen Webtechnologien wie Webservices vollautomatisch erfolgen kann und somit keinerlei Mensch-Maschine-Interaktion mehr erfordert.

Um die Rechner in ihrer Funktion wieder zu einem Rechenzentrum zusammenzuschließen, werden diese zu einem oder mehreren großen verteilten Cloud-Rechenzentren zusammengefasst. Die Berechnungen auf einem Rechner werden dem Heizbedarf eines Hauses entsprechend moduliert. Die Recheneinheiten selbst treten in Gebäuden anstelle des klassischen Heizungssystems und werden beispielsweise in Technikräumen genau an dem Ort installiert, an dem sonst eine Heizungsanlage ihren Platz findet. Der Platzbedarf und die Investitionskosten der individuellen dezentralen (d.h. geographisch verteilten) Anlagen liegen vergleichbar oder sogar unter denen einer modernen Wärmepumpenheizung.

Gemäß verschiedenen Ausführungsbeispielen wird die Möglichkeit bereitgestellt, die Rechenleistung der Rechner so zu modulieren, dass diese wärmegeführt betrieben werden. Wird eine hohe Wärmelast benötigt, werden alle Rechner mit maximaler Rechenlast beaufschlagt. Die Modulation der Rechen- und der Heizleistung kann darüber hinaus nach ökonomischen oder ökologischen Aspekten erfolgen. Dies können zum Beispiel eine Modulation der Rechenleistung in Abhängigkeit von der Verfügbarkeit regenerativer Quellen (Solarkraft, Windkraft) und/oder in Abhängigkeit der aktuellen Stromerstehungspreise sein.

Weitere Vorteile sind eine Kostenreduktion im Gebäudeheizungssektor, eine Kostenreduktion beim Betrieb von Rechenzentren, sowie die Vermeidung des Klimagases CO₂.

Für den Betreiber eines Rechenzentrums ergeben sich bei Einsatz des hier vorgeschlagenen Konzepts viele Vorteile. Das Heizsystem ermöglicht es, über 50% der Kosten eines klassischen Rechenzentrums einzusparen. Dessen Gesamtkosten setzen sich zum einen zusammen aus der Abschreibung der Investition, Zinsen und dem operativen Betrieb der Rechner, zum anderen aus Kosten für die Infrastruktur und Kühlung (Gebäude und Rechner).

Da das Heizsystem-Netzwerk den Ansatz verfolgt, die Rechner dort zu betreiben, wo Wärme gebraucht wird und bereits Räumlichkeiten zur Verfügung stehen, können die Kosten der Infrastruktur und Kühlung somit komplett eliminiert werden. Dieser Kostenblock macht 60% aller Ausgaben eines modernen Rechenzentrums aus. Diese Kosten lassen sich größtenteils einsparen. Unter Berücksichtigung der geringfügig erhöhten administrativen Kosten für die dezentrale Heizsystem-Infrastruktur kann bei dem zu Grunde liegenden Geschäftsmodell davon ausgegangen werden, dass eine reale Kosteneinsparung von 51% erreicht werden kann, die je nach Geschäftsmodell an Rechenzentrenbetreiber und/oder Gebäudebesitzer weitergereicht werden kann.

Auch für den Gebäudebesitzer bringt das Heizsystem Vorteile mit sich. Mit dem Heizsystem erwirbt der Gebäudebesitzer ein kostensparendes Heizungssystem, das den Heizwärmebedarf seines Gebäudes deckt und optional die gesamte Warmwasseraufbereitung sicherstellt. Dieses bietet beispielsweise den Vorteil der Reduktion oder Elimination der jährlichen Betriebskosten. Je nach Kostenmodell könnte in einem möglichen Modell der Gebäudebesitzer für einen Zeitraum von 10 Jahren von Betriebs- und/oder Wartungskosten für sein Heizungssystem befreit werden. Diese Kosten könnten von dem Betreiber der Cloud-Umgebung übernommen werden. Ein weiterer Vorteil liegt darin, dass die Investitionskosten je nach Geschäftsmodell äquivalent oder geringer als bei einer Wärmepumpenheizung sind. Für das Heizsystem gemäß verschiedener Ausführungsbeispiele bedarf es der gleichen oder weniger Stellfläche wie für eine Wärmepumpe. Ein noch weiterer Vorteil liegt darin, dass es regelmäßigen Wartungs- und Schornsteinfegerkosten entfallen. Eine klassische Heizungsanlage für Niedrigstenerige-Neubauten ist häufig überdimensioniert und erzeugt im Falle der Verbrennung von fossilen Brennstoffen regelmäßige Wartungs- und Schornsteinfegerkosten, die beim Einsatz des hier beschriebenen Heizsystems entfallen würden. Da ferner auf einen Schornstein verzichtet werden kann, entfallen auch die damit verbundenen Investitionen. Ein noch weiterer Vorteil kann darin gesehen werden, dass Solarstrom verfügungsabhängig genutzt werden kann. Das Heizsystem bietet die Möglichkeit regenerative Energiequellen lokal und produktionsabhängig zu nutzen und Überkapazitäten abzupuffern. Wird der schwankende Strompreis in künftigen Einspeisevergütungen und Verbrauchsmodellen (beispielsweise mittels "Smart Meter", also intelligenter Stromzähler) berücksichtigt, kann das Heizsystem dies sowohl beim Strombezug als auch bei der Einspeisung von Solarstrom nutzen und Geld für den Gebäudebesitzer sparen bzw. erwirtschaften.

Auch für die Umwelt ergeben sich viele Vorteile bei Einsatz des Heizsystems gemäß verschiedenen Ausführungsbeispielen. Bei Einsatz des hier vorgeschlagenen Heizsystems würde allein auf Deutschland bezogen der Umwelt bis zu 1,65 Millionen Tonnen CO₂ pro Jahr erspart bleiben, was zu einer erheblichen Reduktion des CO₂-Ausstoßes beitragen würde. Diese Einsparung resultiert zum einen durch den Wegfall des Kühlenergieverbrauchs der Rechner, zum anderen durch das "Recycling" der Abwärme zur Gebäudeheizung. Zum Vergleich betrugen im Jahre 2005 die durch den nationalen Flugverkehr bedingten CO₂-Emissionen 1,3 Millionen Tonnen. Die oben genannten Einsparungen gehen allerdings davon aus, dass alle Rechenzentren durch das (die) hier vorgestellte(n) Heizsystem bzw. Heizsystem-Netzwerke ersetzt werden würden. In einem konservativen Szenario, das mittelfristig 10% aller Rechenzentren in Deutschland durch die in dieser Anmeldung beschriebenen Heizsysteme ersetzen würde, stünde eine Energiemenge von 1,01 Milliarden Kilowattstunden zur Raumheizung zur Verfügung (Stand: 2011). Dies entspricht der Energiemenge, die zur Raumheizung aller in Deutschland erreichten Neubauten erforderlich ist. Für die Umwelt ergibt sich noch ein weiter Vorteil aus der Tatsache heraus, dass der Bau neuer Rechenzentren aufgrund des gestiegenen Bedarfs überflüssig wird. Dadurch werden Ressourcen, Energie und Flächenverbrauch eingespart, die jeder Neubau eines Rechenzentrums mit sich bringen würde. Dieser Betrachtung unterliegt die Annahme, dass Heizsystem-Netzwerke mit dem bestehenden oder in Kürze verfügbaren Breitbandnetz realisiert werden können.

## Patentansprüche

1. Heizsystem (106) zum Heizen eines Gebäudes (104) und/oder zur Warmwasserbereitung und zur Integration in ein Heizsystem-Netzwerk mit einer Vielzahl von Heizsystemen (106), das Heizsystem aufweisend:
• eine Wärmeverteilungseinrichtung; und
• mindestens einen Rechner (102), wobei der Rechner (102) mit der Wärmeverteilungseinrichtung derart gekoppelt ist, dass die von ihm erzeugte Wärme mittels der Wärmeverteilungseinrichtung im Gebäude (104) verteilt werden kann,
• wobei der Rechner (102) so eingerichtet ist, dass er eine Nachricht für einen Rechenlastverteilungs-Rechner (100), der Rechenaufgaben an die Rechner (102) der Heizsysteme (106) des Heizsystem-Netzwerks verteilt und koordiniert, erzeugt, wobei die Nachricht eine Information über einen Wärmebedarf des Heizsystems (106) und/oder des Gebäudes (104) enthält, und
• wobei der Rechner (102) einen Empfänger aufweist, der eingerichtet ist zum Empfangen einer oder mehrerer Nachrichten von dem Rechenlastverteilungs-Rechner (100), wobei in der einen oder den mehreren Nachrichten die Durchführung von Berechnungen angefordert wird, und wobei der Rechner (102) derart eingerichtet ist, dass er die mittels der einen oder mehreren empfangenen Nachrichten angeforderten Berechnungen durchführt.

2. Heizsystem (106) gemäß Anspruch 1,
wobei der Rechner (102) so eingerichtet ist, dass das Einschalten oder Ausschalten des Rechners (102) in Reaktion auf den Empfang einer von dem Rechenlastverteilungs-Rechner (100) empfangenen Einschalt/Ausschalt-Nachricht erfolgt.

3. Heizsystem (106) gemäß einem der Ansprüche 1 bis 2, ferner aufweisend:
eine Steuereinrichtung, die mit dem Rechner (102) gekoppelt ist oder mittels des Rechners (102) implementiert ist, wobei die Steuereinrichtung eingerichtet ist zum Steuern des Heizsystems (106);
wobei vorzugsweise die Steuereinrichtung eingerichtet ist zum Erfassen von mindestens einem für den Betrieb des Heizsystems (106) erforderlichen Parameters.

4. Rechner (102) zum Heizen eines Gebäudes (104) und/oder zur Warmwasserbereitung,
• wobei der Rechner (102) mehrere Rechenknoten aufweist, wobei jeder der Rechenknoten ein Mainboard mit mindestens einem Prozessor mit mindestens einem Kern aufweist,
• wobei der Rechner (102) mit einer Wärmeverteilungseinrichtung derart koppelbar ist, dass die von ihm erzeugte Wärme mittels der Wärmeverteilungseinrichtung im Gebäude (104) verteilt werden kann,
• wobei der Rechner (102) so eingerichtet ist, dass er eine Nachricht für einen Rechenlastverteilungs-Rechner (100), der Rechenaufgaben an Rechner (102) einer Vielzahl von Heizsystemen (106) verteilt und koordiniert, erzeugt, wobei die Nachricht eine Information über einen Wärmebedarf des Heizsystems (106) und/oder des Gebäudes (104) enthält, und
• wobei der Rechner (102) einen Empfänger aufweist, der eingerichtet ist zum Empfangen einer oder mehrerer Nachrichten von dem Rechenlastverteilungs-Rechner (100), wobei in der einen oder den mehreren Nachrichten die Durchführung von Berechnungen angefordert wird, und wobei der Rechner (102) derart eingerichtet ist, dass er die mittels der einen oder mehreren empfangenen Nachrichten angeforderten Berechnungen durchführt.

5. Rechner (102) gemäß Anspruch 4,
wobei der Rechner (102) so eingerichtet ist, dass das Einschalten oder Ausschalten des Rechners (102) in Reaktion auf den Empfang einer von einem Rechenlastverteilungs-Rechner (100) empfangenen Einschalt/Ausschalt-Nachricht erfolgt.

6. Verfahren zum Betreiben eines Heizsystems (106), welches mindestens einen Rechner (102) aufweist und in ein Heizsystem-Netzwerk mit einer Vielzahl von Heizsystemen (106) integriert ist, zum Heizen eines Gebäudes (104) und/oder zur Warmwasserbereitung, wobei das Verfahren aufweist:
• Ermitteln eines Wärmebedarfs des Heizsystems (106) und/oder des Gebäudes (104) und/oder des Wassers;
• Erzeugen einer Nachricht für einen Rechenlastverteilungs-Rechner (100), der Rechenaufgaben an den mindestens einen Rechner (102) des Heizsystems (106) verteilt und koordiniert, mit einer Information über den Wärmebedarf des Heizsystems (106) und/oder des Gebäudes (104) mittels des Rechners (102); und
• Empfangen mittels eines Empfängers des Rechners (102) einer oder mehrerer Nachrichten von dem Rechenlastverteilungs-Rechner (100), wobei in der einen oder den mehreren Nachrichten die Durchführung von Berechnungen angefordert wird, und wobei der Rechner (102) mittels der einen oder mehreren empfangenen Nachrichten angeforderten Berechnungen durchführt.

7. Rechenlastverteilungs-Rechner (100) zum Verteilen und Koordinieren von Rechenaufgaben an Rechner (102) eines Heizsystem-Netzwerks, welches eine Vielzahl von Heizsystemen (106) aufweist, wobei die Rechner (102) Teil der Heizsysteme (106) sind und die Heizsysteme (106) Wärmeverteilungseinrichtungen zur Verteilung der von den Rechnern (102) erzeugten Wärme aufweisen, wobei der Rechenlastverteilungs-Rechner (100) aufweist:
• einen Empfänger, der derart eingerichtet ist, dass er mindestens eine Nachricht von mindestens einem Rechner (102) empfängt, wobei die mindestens eine Nachricht eine Information über einen Wärmebedarf eines Heizsystems (106) und/oder eines Gebäudes (104) und/oder einer Warmwasserbereitung enthält, und
• wobei der Rechenlastverteilungs-Rechner (100) eingerichtet ist zum Erzeugen mindestens einer Nachricht an den mindestens einen Rechner (102), wobei mittels der mindestens einen Nachricht Berechnungen angefordert werden, wobei die angeforderten Berechnungen bestimmt werden unter Verwendung des von dem jeweiligen Rechner (102) empfangenen Wärmebedarfs des Heizsystems (106), in dem der Rechner (102) angeordnet ist.

8. Rechenlastverteilungs-Rechner (100) gemäß Anspruch 7, ferner aufweisend:
eine mit dem Sender gekoppelte Einschalt/Ausschalt-Nachricht-Erzeugungseinheit, die eingerichtet ist zum Erzeugen der Einschalt/Ausschalt-Nachricht.

9. Rechenlastverteilungs-Rechner (100) gemäß Anspruch 7, der derart eingerichtet ist, dass die angeforderten Berechnungen bestimmt werden in Abhängigkeit von dem Wärmebedarf des Heizsystems (106) und/oder des Gebäudes (104) und/oder einer Priorität der Berechnungen und/oder einer freien Rechenkapazität des Rechners (102) und /oder einer Verfügbarkeit einer erforderlichen Infrastruktur und/oder einem Strombezugspreis und/oder einem Angebot an regenerativ erzeugtem Strom und/oder einem Ladezustand und/oder einer Verfügbarkeit eines Wärmespeichers (448) des Heizsystems (106) und/oder des Gebäudes (104).

10. Verfahren zum Betreiben eines Rechenlastverteilungs-Rechners (100), wobei das Verfahren aufweist:
• Empfangen von mindestens einer Nachricht von mindestens einem Rechner (102) eines Heizsystem-Netzwerks, welches eine Vielzahl von Heizsystemen (106) aufweist, wobei die Rechner (102) Teil der Heizsysteme (106) sind und die Heizsysteme (106) Wärmeverteilungseinrichtungen zur Verteilung der von den Rechnern (102) erzeugten Wärme aufweisen, wobei die mindestens eine Nachricht eine Information über einen Wärmebedarf des Heizsystems (106) und/oder eines Gebäudes (104) und/oder einer Warmwasserbereitung enthält; und
• Erzeugen mindestens einer Nachricht an den mindestens einen Rechner (102), wobei mittels der mindestens einen Nachricht Berechnungen angefordert werden, wobei die angeforderten Berechnungen bestimmt werden unter Verwendung des von dem jeweiligen mindestens einen Rechner (102) empfangenen Wärmebedarfs des Heizsystems (106), in dem der Rechner (102) angeordnet ist.

11. Verfahren gemäß Anspruch 10, ferner aufweisend:
• Empfangen einer Einschalt/Ausschalt-Nachricht, wobei die Einschalt/Ausschalt-Nachricht spezifiziert, ob der mindesten eine Rechner (102) eingeschaltet oder ausgeschaltet werden soll, indem der Rechner hochgefahren oder heruntergefahren wird; und
• Einschalten oder Ausschalten des Rechners (102) in Abhängigkeit von der empfangenen Einschalt/Ausschalt-Nachricht.

## Claims

1. A heating system (106) for heating a building (104) and/or for preparing hot water and for integration into a heating system network with a plurality of heating systems (106), the heating system comprising:
• a heat distributing device; and
• at least one computer (102), wherein the computer (102) is coupled to the heat distributing device in such a way that the heat produced by the computer can be distributed in the building (104) by means of the heat distributing device,
• wherein the computer (102) is configured in such a way that it produces a message for a computing load distribution computer (100) distributing and coordinating computing tasks to the computers (102) of the heating systems (106) of the heating system network, wherein the message contains information about a heat demand of the heating system (106) and/or the building (104), and
• wherein the computer (102) comprises a receiver that is configured to receive one or more messages from the computing load distribution computer (100), wherein the execution of calculations is requested in the one or more messages, and wherein the computer (102) is configured in such a way that it carries out the calculations requested by means of the one or more received messages.

2. The heating system (106) according to claim 1,
wherein the computer (102) is configured in such a way that the computer (102) is switched respectively on and off in reaction to the reception of a switch-on/switch-off message received from the computing load distribution computer (100).

3. The heating system (106) according to one of claims 1 to 2, further comprising:
a control device which is coupled to the computer (102) or is implemented by means of the computer (102), wherein the control device is configured to control the heating system (106), wherein preferably the control device is configured to acquire at least one parameter which is necessary to operate the heating system (106).

4. A computer (102) for heating a building (104) and/or for preparing hot water,
• wherein the computer (102) comprises a plurality of computing nodes, wherein each of the computing nodes comprises a mainboard having at least one processor having at least one core,
• wherein the computer (102) can be coupled to a heat distributing device in such a way that the heat produced by the computer can be distributed in the building (104) by means of the heat distributing device,
• wherein the computer (102) is configured in such a way that it produces a message for a computing load distribution computer (100) distributing and coordinating computing tasks to computers (102) of a plurality of heating systems (106), wherein the message contains information about a heat demand of the heating system (106) and/or the building (104), and
• wherein the computer (102) comprises a receiver that is configured to receive one or more messages from the computing load distribution computer (100), wherein execution of calculations is requested in the one or more messages, and wherein the computer (102) is configured in such a way that it carries out the calculations requested by means of the one or more received messages.

5. The computer (102) according to claim 4,
wherein the computer (102) is configured in such a way that the computer (102) is switched respectively on and off in reaction to the reception of a switch-on/switch-off message received from a computing load distribution computer (100).

6. A method for operating a heating system (106), which comprises at least one computer (102) and is integrated into a heating system network having a plurality of heating systems (106), for heating a building (104) and/or preparing hot water, the method comprising:
• determining a heat demand of the heating system (106) and/or of the building (104) and/or of the water;
• producing a message for a computing load distribution computer (100) coordinating an distributing computing tasks to the at least one computer (102) of the heating system (106), containing information about the heat demand of the heating system (106) and/or of the building (104) by means of the computer (102); and
• receiving, by means of a receiver of the computer (102), one or more messages from the computing load distribution computer (100), wherein in the one or more messages execution of calculations is requested, and wherein the computer (102) carries out the calculations requested by means of the one or more received messages.

7. A computing load distribution computer (100) for distributing and coordinating computing tasks to computers (102) of a heating system network that comprises a plurality of heating systems (106), wherein the computers (102) are part of the heating systems (106) and the heating systems (106) comprise heat distributing devices for distributing the heat generated by the computers (102), wherein the computing load distribution computer (100) comprises:
• a receiver which is configured in such a way that it receives at least one message from at least one computer (102), wherein the at least one message contains information about a heat demand of a heating system (106) and/or of a building (104) and/or of a hot water preparation, and
• wherein the computing load distribution computer (100) is configured to generate at least one message to the at least one computer (102), wherein calculations are requested by means of the at least one message, wherein the requested calculations are determined by using the heat demand received from the respective computer (102) of the heating system (106), in which the computer (102) is positioned.

8. The computing load distribution computer (100) according to claim 7, further comprising:
a switch-on/switch-off message producing unit which is coupled to the transmitter and which is configured to produce the switch-on/switch-off message.

9. The computing load distribution computer (100) according to claim 7, configured in such a way that the requested calculations are determined as a function of the heat demand of the heating system (106) and/or of the building (104) and/or of a priority of the calculations and/or of a free computing capacity of the computer (102) and/or of an availability level of a necessary infrastructure and/or a price paid for electricity and/or a supply level of regeneratively generated electricity and/or a state of charge and/or an availability level of a heat accumulator (448) of the heating system (106) and/or of the building (104).

10. A method for operating a computing load distribution computer (100), the method comprising:
• receiving at least one message from at least one computer (102) of a heating system network comprising a plurality of heating systems (106), wherein the computers (102) are part of the heating systems (106) and the heating systems (106) comprise heat distributing devices for distributing the heat generated by the computers (102), wherein the at least one message contains information about a heat demand of the heating system (106) and/or a building (104) and/or a hot water preparation; and
• generating at least one message to the at least one computer (102), wherein calculations are requested by means of the at least one message, wherein the requested calculations are determined by using the heat demand received from the respective at least one computer (102) of the heating system (106), in which the computer (102) is positioned.

11. The method according to claim 10, further comprising:
• receiving a switch-on/switch-off message, wherein the switch-on/switch-off message specifies whether the at least one computer (102) is to be switched on or switched off by powering the computer up or down; and
• switching the computer (102) on or off as a function of the received switch-on/switch-off message.

## Revendications

1. Système de chauffage (106) pour le chauffage d'un bâtiment (104) et/ou pour la production d'eau chaude et destiné à une intégration dans un réseau de systèmes de chauffage avec une pluralité de systèmes de chauffage (106), ce système de chauffage comprenant :
• un dispositif de répartition de la chaleur ; et
• au moins un calculateur (102), le calculateur (102) étant couplé avec le dispositif de répartition de la chaleur de façon à ce que la chaleur qu'il génère puisse être répartie dans le bâtiment (104) au moyen du dispositif de répartition de la chaleur,
• le calculateur (102) étant conçu de façon à ce qu'il génère un message pour un calculateur de répartition de charge de calcul (100), qui répartit et coordonne les tâches de calcul au niveau des calculateurs (102) des systèmes de chauffage (106) du réseau de systèmes de chauffage, le message contenant une information concernant les besoins en chaleur du système de chauffage (106) et/ou du bâtiment (104) et
• le calculateur (102) comprenant un récepteur qui est conçu pour la réception d'un ou de plusieurs messages provenant du calculateur de répartition de charge de calcul (100), la réalisation de calculs étant demandée dans le ou les messages, et le calculateur (102) étant conçu de façon à ce qu'il réalise, au moyen du ou des messages reçus, les calculs demandés.

2. Système de chauffage (106) selon la revendication 1,
le calculateur (102) étant conçu de façon à ce que la mise en marche ou l'arrêt du calculateur (102) ait lieu en réponse à la réception d'un message de mise en marche / d'arrêt reçu en provenance du calculateur de répartition de charge de calcul (100).

3. Système de chauffage (106) selon l'une des revendications 1 à 2, comprenant en outre :
un dispositif de commande qui est couplé avec le calculateur (102) ou qui est implémenté à l'aide du calculateur (102), le dispositif de commande étant conçu pour le contrôle du système de chauffage (106) ;
de préférence, le dispositif de commande étant conçu pour la mesure d'au moins un paramètre nécessaire pour le fonctionnement du système de chauffage (106).

4. Calculateur (102) pour le chauffage d'un bâtiment (104) et/ou pour la production d'eau chaude,
• le calculateur (102) comprenant plusieurs noeuds de calcul, chacun des noeuds de calcul comprenant une carte-mère avec au moins un processeur avec au moins un noyau,
• le calculateur (102) pouvant être couplé avec un dispositif de répartition de chaleur de façon à ce que la chaleur qu'il génère puisse être répartie dans le bâtiment (104) au moyen du dispositif de répartition de chaleur,
• le calculateur (102) étant conçu de façon à ce qu'il génère un message pour un calculateur de répartition de charge de calcul (100), qui répartit et coordonne les tâches de calcul au niveau des calculateurs (102) d'une pluralité de systèmes de chauffage (106), le message contenant une information concernant les besoins en chaleur du système de chauffage (106) et/ou du bâtiment (104) et
• le calculateur (102) comprenant un récepteur qui est conçu pour la réception d'un ou de plusieurs messages provenant du calculateur de répartition de charge de calcul (100), la réalisation de calculs étant demandée dans le ou les messages, et le calculateur (102) étant conçu de façon à ce qu'il réalise, au moyen du ou des messages reçus, les calculs demandés.

5. Calculateur (102) selon la revendication 4,
le calculateur (102) étant conçu de façon à ce que la mise en marche ou l'arrêt du calculateur (102) ait lieu en réponse à la réception d'un message de mise en marche / d'arrêt reçu en provenance du calculateur de répartition de charge de calcul (100).

6. Procédé d'exploitation d'un système de chauffage (106), qui comprend au moins un calculateur (102) et qui est intégré dans un réseau de systèmes de chauffage avec une pluralité de systèmes de chauffage (106), pour le chauffage d'un bâtiment (104) et/ou pour la production d'eau chaude, ce procédé comprenant :
• la détermination des besoins en chaleur du système de chauffage (106) et/ou du bâtiment (102) et/ou de l'eau ;
• la génération d'un message pour un calculateur de répartition de charge de calcul (100), qui répartit et coordonne les tâches de calcul au niveau de l'au moins un calculateur (102) du système de chauffage (106), contenant une information concernant les besoins en chaleur du système de chauffage (106) et/ou du bâtiment (104) au moyen du calculateur (102) ; et
• la réception, au moyen d'un récepteur du calculateur (102), d'un ou de plusieurs messages en provenance du calculateur de répartition de charge de calcul (100), la réalisation de calculs étant demandée dans le ou les messages, et le calculateur (102) réalisant les calculs demandés au moyen du ou des messages reçus.

7. Calculateur de répartition de charge de calcul (100) pour la répartition et la coordination des tâches de calcul au niveau de calculateurs (102) d'un réseau de systèmes de chauffage, qui comprend une pluralité de systèmes de chauffage (106), les calculateurs (102) faisant partie des systèmes de chauffage (106) et les systèmes de chauffage (106) comprenant des dispositifs de répartition de la chaleur pour la répartition de la chaleur générée par les calculateurs (102), le calculateur de répartition de charge de calcul (100) comprenant :
• un récepteur qui est conçu de façon à recevoir au moins un message en provenance d'au moins un calculateur (102), l'au moins un message contenant une information concernant les besoins en chaleur d'un système de chauffage (106) et/ou d'un bâtiment (104) et/ou d'une production d'eau chaude et
• le calculateur de répartition de charge de calcul (100) étant conçu pour la génération d'au moins un message pour l'au moins un calculateur (102), des calculs étant demandés au moyen de l'au moins un message, les calculs demandés étant déterminés à l'aide des besoins en chaleur reçus par le calculateur (102) respectif en provenance du système de chauffage (106) dans lequel le calculateur (102) est disposé.

8. Calculateur de répartition de charge de calcul (100) selon la revendication 7, comprenant en outre :
une unité de génération de message de mise en marche / d'arrêt qui est conçue pour la génération du message de mise en marche / d'arrêt et qui est couplée à l'émetteur.

9. Calculateur de répartition de charge de calcul (100) selon la revendication 7, qui est conçu de façon à ce que les calculs demandés soient déterminés en fonction des besoins en chaleur du système de chauffage (106) et/ou du bâtiment (104) et/ou d'une priorité des calculs et/ou d'une capacité de calcul disponible du calculateur (102) et/ou d'une disponibilité d'une infrastructure nécessaire et/ou d'un prix de référence du courant et/ou d'une offre de courant produit de manière régénérative et/ou d'un état de charge et/ou d'une disponibilité d'un accumulateur de chaleur (448) du système de chauffage (106) et/ou du bâtiment (104).

10. Procédé d'exploitation d'un calculateur de répartition de charge de calcul (100), ce procédé comprenant :
• la réception d'au moins un message en provenance d'au moins un calculateur (102) d'un réseau de systèmes de chauffage, qui comprend une pluralité de systèmes de chauffage (106), les calculateurs (102) faisant partie des systèmes de chauffages (106) et les systèmes de chauffage (106) comprenant des dispositifs de répartition de chaleur pour la répartition de la chaleur générée par les calculateurs (102), l'au moins un message contenant une information concernant les besoins en chaleur du système de chauffage (106) et/ou d'un bâtiment (104) et/ou d'une production d'eau chaude ; et
• la génération d'au moins un message à l'attention d'au moins un calculateur (102), des calculs étant demandés au moyen de l'au moins un message, les calculs demandés étant déterminés à l'aide des besoins en chaleur reçus par l'au moins un calculateur (102) respectif en provenance du système de chauffage (106) dans lequel le calculateur (102) est disposé.

11. Procédé selon la revendication 10, comprenant en outre :
• la réception d'un message de mise en marche / d'arrêt, le message de mise en marche / d'arrêt spécifiant si l'au moins un calculateur (102) doit être mis en marche ou arrêté, le calculateur étant alors démarré ou arrêté ; et
• la mise en marche ou l'arrêt du calculateur (102) en fonction du message de mise en marche / d'arrêt reçu.
